Europäisches Patentamt

European Patent Office

Office européen des brevets

(19)

(11) **EP 0 827 285 B1**

(12) **FASCICULE DE BREVET EUROPEEN**

(45) Date de publication et mention
de la délivrance du brevet:
**15.01.2003 Bulletin 2003/03**

(51) Int Cl.⁷: **H03M 13/00**

(21) Numéro de dépôt: **97401988.7**

(22) Date de dépôt: **26.08.1997**

(54) **Procédé de transmission de bits d'information avec codage correcteur d'erreurs, codeur et décodeur pour la mise en oeuvre de ce procédé**

Informationsbits-Übertragungsverfahren mit Fehlerkorrektur-Kodierung, Kodier- und Dekodiervorrichtung dafür

Information bits transmission process with error correction coding, and coder and decoder therefor

(84) Etats contractants désignés:
**DE GB**

(30) Priorité: **28.08.1996 FR 9610520**

(43) Date de publication de la demande:
**04.03.1998 Bulletin 1998/10**

(73) Titulaire: **FRANCE TELECOM**
**75015 Paris (FR)**

(72) Inventeurs:
• **Pyndiah, Ramesh**
**29280 Plouzane (FR)**
• **Adde, Patrick**
**29200 Brest (FR)**

(74) Mandataire: **Burbaud, Eric et al**
**Cabinet Plasseraud**
**84, rue d'Amsterdam**
**75440 Paris Cédex 09 (FR)**

(56) Documents cités:
**EP-A- 0 654 910      GB-A- 2 095 517**
**GB-A- 2 180 966      US-A- 5 181 207**

• **RAMESH PYNDIAH ET AL: "NEAR OPTIMUM DECODING OF PRODUCT CODES" PROCEEDINGS OF THE GLOBAL TELECOMMUNICATIONS CONFERENCE (GLOBECOM), SAN FRANCISCO, NOV. 28 - DEC. 2, 1994, vol. 1 OF 3, 28 novembre 1994, INSTITUTE OF ELECTRICAL AND ELECTRONICS ENGINEERS, pages 339-343, XP000488569**
• **BATE S D ET AL: "ERROR CONTROL TECHNIQUES APPLICABLE TO HF CHANNELS" IEE PROCEEDINGS I. SOLID- STATE & ELECTRON DEVICES, vol. 136, no. 1, PART 1, février 1989, pages 57-63, XP000047678**
• **LODGE J ET AL: "SEPARABLE MAP "FILTERS" FOR THE DECODING OF PRODUCT AND CONCATENATED CODES" PROCEEDINGS OF THE INTERNATIONAL CONFERENCE ON COMMUNICATIONS (ICC), GENEVA, MAY 23 - 26, 1993, vol. 3/3, 23 mai 1993, INSTITUTE OF ELECTRICAL AND ELECTRONICS ENGINEERS, pages 1740-1745, XP000448423**
• **BERROU C ET AL: "NEAR SHANNON LIMIT ERROR - CORRECTING CODING AND DECODING: TURBO-CODES (1)" PROCEEDINGS OF THE INTERNATIONAL CONFERENCE ON COMMUNICATIONS (ICC), GENEVA, MAY 23 - 26, 1993, vol. 1 - 2 - 03, 23 mai 1993, INSTITUTE OF ELECTRICAL AND ELECTRONICS ENGINEERS, pages 1064-1070, XP000371240**

**Description**

La présente invention concerne un procédé pour transmettre des bits d'information, dans lequel un émetteur exécute les étapes suivantes :

- formation d'une première matrice binaire à partir des bits d'information à transmettre ;
- transformation de la première matrice binaire en une seconde matrice binaire par application d'un code en blocs systématique correspondant au produit de codes en blocs systématiques élémentaires ; et
- émission vers un canal de bits extraits de la seconde matrice binaire,

et un récepteur exécute les étapes suivantes :

- formation d'une matrice d'entrée à partir d'un signal reçu selon ledit canal, la matrice d'entrée ayant la même taille que la seconde matrice binaire, et se composant d'échantillons numériques dont les signes représentent des estimations initiales respectives des bits de la seconde matrice binaire et dont les valeurs absolues mesurent respectivement des confiances associées auxdites estimations initiales ; et
- décodage itératif de la matrice d'entrée incluant un nombre m de cycles de décodage, chaque cycle de décodage comportant successivement des étapes de recherche des mots de code pour chaque code en blocs élémentaire utilisé dans le code produit,

dans lequel, à chaque étape de recherche de mots de code, on reçoit une matrice de données et une matrice de décision à composantes binaires qui, avant la première étape de recherche du décodage itératif, sont respectivement constituées par la matrice d'entrée et par une matrice dont les composantes binaires correspondent aux signes des échantillons de la matrice d'entrée, et on produit pour l'étape de recherche suivante une nouvelle matrice de décision dont les composantes binaires représentent de nouvelles estimations respectives des bits de la seconde matrice binaire et une nouvelle matrice de données dont les échantillons ont des valeurs absolues qui mesurent respectivement des confiances associées auxdites nouvelles estimations,

dans lequel les bits d'information décodés sont extraits de la matrice de décision produite lors de la dernière étape de recherche de mots de code,

et dans lequel chaque étape de recherche de mots de code comporte une division de la matrice de données reçue en vecteurs de données correspondant chacun à un mot de code du code élémentaire et une division correspondante de la matrice de décision reçue en vecteurs de décision et des décodages élémentaires à décisions douces pour traiter respectivement certains au moins des couples vecteur de données/vecteur de décision.

En matière de transmission numérique de l'information (parole, image, données...), on distingue habituellement entre le codage source et le codage canal. Le codage source forme la représentation binaire du signal à transmettre. Il est normalement conçu en fonction de la nature du signal à transmettre. Beaucoup d'efforts ont été effectués ces dernières années en matière de codage source pour réduire le débit numérique tout en conservant une bonne qualité de transmission. Mais ces nouvelles techniques de codage source nécessitent une meilleure protection des bits vis-à-vis des perturbations lors de la transmission. D'autre part, les limitations physiques et économiques des composants haute fréquence (facteur de bruit, saturation de la puissance) ainsi que la réglementation sur le niveau de puissance autorisé à l'émission limitent la portée des systèmes de transmission numérique.

C'est pourquoi beaucoup de travaux ont été effectués en matière de codage canal, en particulier en matière de codage en blocs. Ce type de codage correcteur d'erreurs consiste à ajouter, à k bits d'information issus du codage source, n-k bits de redondance, et à utiliser ces bits de redondance à la réception pour corriger certaines erreurs de transmission. On appelle rendement du code le rapport R=k/n, et on définit le gain de codage G comme le rapport, exprimé en décibels, entre les énergies par bit d'information Eb nécessaires à l'entrée du récepteur sans codage et avec codage pour atteindre un taux d'erreur binaire (TEB) donné. Un objectif typique est de réaliser des codeurs et surtout les décodeurs associés de façon que : (i) le gain de codage G soit Le plus élevé (G > 5 dB pour TEB = $10^{-5}$), (ii) le rendement du code soit le plus élevé (R > 0,6), et (iii) la complexité de décodage soit la plus faible.

Le cas du stockage de l'information numérique peut être vu comme un cas particulier de la transmission, dans lequel le canal de propagation inclut une mémoire dans laquelle l'information reste stockée plus ou moins longtemps, l'émetteur et le récepteur pouvant être confondus ou non. On comprendra donc qu'en général, les notions de codage canal et de décodage associé sont applicables au domaine du stockage de l'information de la même manière qu'à la transmission, les erreurs à corriger étant alors celles dues à la lecture ou à l'écriture dans la mémoire, à l'altération du contenu de la mémoire ou encore aux communications (à distance ou non) avec les dispositifs de lecture et d'écriture dans la mémoire.

Il est connu d'améliorer les performances des codes correcteurs d'erreurs en utilisant des techniques de concaténation. En particulier, la technique des codes produits, qui est plus précisément concernée par la présente invention, permet d'obtenir à partir de deux codes en blocs simples (c'est-à-dire ayant une faible distance de Hamming minimale d), un code dont la distance de Hamming minimale est égale au produit des distances de Hamming des codes élémentaires utilisés (voir S.M. Reddy : "On decoding iterated codes", IEEE Trans. on Information theory, Vol. IT-16, N°5, Septembre 1970, pages 624-627).

Si on désigne par $C_1$ un code en blocs de paramètres $(n_1,k_1,d_1)$ et par $C_2$ un code en blocs de paramètres $(n_2,k_2,d_2)$, l'application du code produit de $C_1$ par $C_2$ consiste à ordonner les $k_1 \times k_2$ bits d'information successifs dans une matrice, et à coder les $k_1$ lignes de la matrice par le code $C_2$, puis les $n_2$ colonnes de la matrice résultante par le code $C_1$. Les paramètres du code produit P sont alors donnés par $(n = n_1 \times n_2 ; k = k_1 \times k_2 ; d = d_1 \times d_2)$. Le rendement R du code P est égal à $R_1 \times R_2$. Le décodage du code P suivant le maximum de vraisemblance a posteriori (MVP) permet d'atteindre les performances optimales. Le gain de codage asymptotique maximal peut alors être approché par la relation $G < 10 \log_{10} (R.d)$.

Le code produit est donc très intéressant, mais le décodage suivant le MVP est généralement trop complexe, sauf dans le cas de codes en blocs courts.

Dans leur article "Separable MAP filters for the decoding of product and concatenated codes", Proc. ICC'93, Genève, Pages 1740-1745, Mai 1993, J. Lodge et al. ont proposé un algorithme itératif de décodage du type indiqué en introduction, dans lequel les vecteurs-ligne et les vecteurs-colonne extraits de la matrice de données sont décodés en utilisant l'algorithme de Bahl (voir L.R.Bahl et al, "Optimal decoding of linear codes for minimizing symbol error rate", IEEE Trans. on Information Theory, Vol. IT-20, pages 248-287, Mars 1974) qui estime les rapports logarithmiques de vraisemblance (LLR pour "Log-Likelihood-Ratio") des bits. L'algorithme de Bahl fournit des décisions douces exprimées par les LLR qui permettent d'atteindre des performances proches du MVP. Mais il fait appel à un treillis de décodage dont le nombre d'états croît exponentiellement en fonction de n-k. En conséquence, si l'algorithme de Lodge et al convient bien pour des codes de longueur faible tels que, par exemple le code de Hamming (16,11,3), il s'avère inutilisable en pratique pour des codes de rendement élevés tels que, par exemple, le code BCH(63,51,5).

Un autre procédé du type indiqué au début a été présenté dans la demande de brevet européen 0 654 910 dont le contenu est incorporé à la présente description.

Ce dernier procédé permet de décoder tous les codes produits qui sont construits à partir de codes en blocs linéaires et pour lesquels on dispose d'un décodeur algébrique. Les performances obtenues avec ce procédé sont quasi-optimales (voir R. Pyndiah et al : "Near optimum decoding of product codes", Proc. IEEE GLOBECOM'94 Conference, Vol. 1/3, Nov.-Déc. 1994, San Francisco, pages 339-343). En effet, il permet d'obtenir, pour un code produit donné et en quatre itérations, un TEB égal à $10^{-5}$ pour un rapport signal-à-bruit qui se situe à environ 2,5 dB au-dessus de la limite théorique de Shannon pour le code produit considéré. D'autre part, la complexité de ce procédé est beaucoup plus faible que celle de la solution proposée par Lodge et al. On est ainsi en mesure de décoder des codes produits de très grande dimension, les longueurs $n_1$, $n_2$ des codes élémentaires pouvant atteindre 256.

Lorsque l'on considère la réalisation d'un circuit apte à réaliser un décodage itératif du type mentionné en introduction, ci-après appelé circuit turbo-code en bloc ou circuit TCB (voir O. Raoul et al, "Architecture et Conception d'un circuit turbodécodeur de codes produits" Proc. GRETSI'95 Conference, Vol.2, septembre 1995, pages 981-984), il apparaît que l'on peut réduire considérablement la surface du circuit en utilisant le même décodeur élémentaire pour effectuer plusieurs itérations au lieu de cascader plusieurs décodeurs élémentaires. Suivant l'application envisagée, le nombre d'itérations sera fonction de la complexité du décodeur élémentaire. Le nombre d'itérations sera d'autant plus grand que la complexité du décodeur élémentaire sera faible d'où l'intérêt de réduire la complexité du décodeur élémentaire.

Pour des raisons économiques, il est souhaitable de disposer d'un circuit TCB programmable qui permette de traiter des blocs de données de tailles différentes avec un nombre de bits de redondance variable. Ainsi on pourra envisager d'utiliser le même circuit TCB pour différentes applications, ce qui permet une économie appréciable en termes de coût de développement.

Un but principal de la présente invention est de répondre à ce besoin en proposant un procédé de transmission de bits d'information autorisant l'emploi d'un circuit TCB programmable.

L'invention propose ainsi, dans un procédé du type indiqué en introduction, que la première matrice binaire comporte, en plus des bits d'information, un ensemble de bits de valeurs connues a priori du récepteur, qui sont distribués de façon sensiblement uniforme suivant chaque dimension de la première matrice binaire, qui se retrouvent après le codage systématique en des positions déterminées de ladite seconde matrice binaire, et qui ne sont pas émis vers le canal, et que le récepteur place dans la matrice d'entrée, en des positions correspondant auxdites positions déterminées de la seconde matrice binaire, des échantillons dont les signes correspondent respectivement aux valeurs connues a priori des bits dudit ensemble et dont les valeurs absolues sont représentatives d'une confiance maximale.

L'invention exploite une technique semblable aux techniques de raccourcissement qui sont bien connues dans le domaine des codes en blocs simples. Soient n, k et d les paramètres du code produit, de la forme :

$$n = \prod_{i=1}^{L} n_i \ , \quad k = \prod_{i=1}^{L} k_i, \quad et \quad d = \prod_{i=1}^{L} d_i$$

où L est le nombre de codes élémentaires dont les paramètres respectifs sont ($n_i$, $k_i$, $d_i$) (dans la suite on considérera le cas L=2 sans limiter la généralité). k et n sont les nombres de bits respectifs des "première" et "seconde" matrices binaires.

L'invention permet d'adapter le nombre de bits d'information indépendants contenus dans la matrice à un nombre quelconque k-X inférieur ou égal à k, le circuit de décodage du récepteur étant le même quel que soit le nombre X des bits connus a priori. Les positions de ces X bits sont distribuées uniformément dans la première matrice, ce qui permet de tirer le meilleur parti des performances du processus de décodage itératif. A cet égard, on note qu'un raccourcissement d'un ou plusieurs des codes en blocs élémentaires serait moins intéressant car il laisserait moins de choix dans la valeur de X, et surtout il mènerait à ce que certains des décodages élémentaires n'apportent aucun gain en TEB.

Les paramètres (n',k',d') du code produit raccourci sont finalement n'=n-X, k'=k-X et d'=d. Son rendement R' est R'=(k-X)/(n-X)≤k/n.

Dans un mode de réalisation avantageux, un autre ensemble de Y bits de positions déterminées dans la seconde matrice binaire ne sont pas émis vers le canal, et le récepteur place dans la matrice d'entrée, en des positions correspondant à ces Y positions déterminées de la seconde matrice binaire, des échantillons dont les valeurs absolues sont représentatives d'une confiance minimale.

On exploite ici une technique de poinçonnage comparable à celles fréquemment utilisées dans le domaine des codes convolutionnels. Le poinçonnage augmente le rendement du code. Dans le cas des codes convolutionnels, son but est généralement d'atteindre les rendements de codage plus grands que 1/2 tout en employant des codes binaires, c'est-à-dire ceux dont les treillis de décodage sont les moins complexes. En général, un code convolutionnel poinçonné a des propriétés de distance semblables à celles d'un code non poinçonné de même rendement.

Mais le poinçonnage n'est normalement pas appliqué aux codes en blocs. En effet, il existe de nombreux codes en blocs de rendement élevé dont les propriétés de distance sont optimales. On s'attendrait donc à ce que le poinçonnage dégrade les propriétés de distance sans procurer un gain en complexité aussi appréciable que dans le cas des codes convolutionnels. Les inventeurs ont constaté de façon surprenante que dans le cas d'un code produit, le poinçonnage appliqué comme indiqué ci-dessus, combiné au processus de décodage itératif à décisions douces, ne dégrade pas de façon significative les performances du codec.

Le paramètre Y permet alors de programmer le nombre de bits par bloc de sortie du codeur, et le rendement de codage global. Par exemple, si la programmation du nombre de bits d'information non redondants par bloc (par l'intermédiaire du nombre X) conduit à trop diminuer le rendement de codage, on peut rétablir un rendement plus élevé si Y>0.

Les paramètres (n",k",d") du code produit raccourci et poinçonné sont finalement n"=n-X-Y, k"=k-X et d"=d. Son rendement R" est R"=(k-X)/(n-X-Y).

Le décodage élémentaire à décisions douces pour le traitement d'un couple vecteur de données/vecteur de décision peut notamment être du type décrit dans EP-A-0 654 910. Il comporte alors les étapes suivantes :

- détermination d'un nombre p d'indices pour lesquels les composantes du vecteur de données sont les moins fiables ;
- construction d'un nombre q de mots binaires à décoder à partir desdits p indices et du vecteur de décision ;
- obtention de q' mots de code sur la base de décodages algébriques du vecteur de décision et des q mots binaires à décoder ;
- sélection, parmi les q' mots de code obtenus, de celui ayant la plus faible distance euclidienne avec le vecteur de données ;
- calcul d'un vecteur de correction, chaque composante $W_j$ du vecteur de correction étant respectivement calculée en déterminant un éventuel mot concurrent ayant sa j-ième composante différente de celle du mot de code sélectionné, et en appliquant la formule :

$$W_j = \left( \frac{|M^c - M^d|}{4} - C_j^d \cdot R_j' \right) C_j^d$$

lorsqu'un mot concurrent a été déterminé, Md et $M^C$ désignant respectivement les distances euclidiennes, par rapport au vecteur de données, du mot de code sélectionné et du mot concurrent, et $C_j^d$ et $R'_j$ désignant respectivement les j-ièmes composantes du mot de code sélectionné et du vecteur de données ;

- obtention du nouveau vecteur de décision pris égal audit mot de code sélectionné ; et
- calcul du nouveau vecteur de données en ajoutant le vecteur de correction multiplié par un premier coefficient de confiance au vecteur d'entrée correspondant extrait de la matrice d'entrée.

Dans un mode de réalisation préféré, dans l'étape de calcul d'un vecteur de correction, la détermination d'un éventuel mot concurrent relativement à la j-ième composante du mot de code sélectionné comprend une comparaison entre la j-ième composante du mot de code sélectionné et celle d'un mot de code candidat qui, parmi les q' mots de code obtenus à l'exception du mot de code sélectionné, a la plus faible distance euclidienne avec le vecteur de données, ledit mot de code candidat étant pris comme mot concurrent lorsque sa j-ième composante est différente de celle du mot de code sélectionné, et aucun mot concurrent n'étant déterminé dans le cas contraire.

Un second aspect de l'invention se rapporte à un codeur à redondance programmable, comportant :

- des moyens pour former une première matrice binaire à partir de bits d'information à transmettre ;
- des moyens de codage élémentaire commandés pour transformer la première matrice binaire en une seconde matrice binaire par application d'un code en blocs systématique correspondant au produit de codes en blocs systématiques élémentaires ; et
- des moyens pour émettre vers un canal des bits extraits de la seconde matrice binaire,

le codeur comprenant en outre des moyens de programmation pour déterminer, à partir d'un nombre X fourni pour programmer le nombre de bits d'information à inclure dans chaque première matrice, X positions uniformément distribuées suivant chaque dimension de la première matrice, les moyens de formation de la première matrice étant agencés pour placer des bits de valeurs connues auxdites X positions, lesdits bits de valeurs connues se retrouvant après le codage systématique en des positions déterminées de la seconde matrice binaire et n'étant pas émis vers le canal.

Un troisième aspect de l'invention se rapporte à un décodeur correcteur d'erreurs programmable, comportant :

- des moyens pour former une matrice d'entrée à partir d'un signal reçu selon un canal de transmission, la matrice d'entrée se composant d'échantillons numériques dont les signes représentent des estimations initiales respectives de bits d'une matrice binaire formée par un codeur à redondance appliquant un code en blocs systématique correspondant au produit de codes en blocs systématiques élémentaires, et dont les valeurs absolues mesurent respectivement des confiances associées auxdites estimations initiales ; et
- des moyens de décodage itératif commandés pour décoder la matrice d'entrée suivant des cycles de décodage successifs, chaque cycle de décodage comportant successivement des étapes de recherche des mots de code pour chaque code en blocs élémentaire utilisé dans le code produit,

dans lequel, à chaque étape de recherche de mots de code, les moyens de décodage reçoivent une matrice de données et une matrice de décision à composantes binaires qui, avant la première étape de recherche, sont respectivement constituées par la matrice d'entrée et par une matrice dont les composantes binaires correspondent aux signes des échantillons de la matrice d'entrée, et produisent pour l'étape de recherche suivante une nouvelle matrice de décision dont les composantes binaires représentent de nouvelles estimations respectives des bits de la seconde matrice binaire et une nouvelle matrice de données dont les échantillons ont des valeurs absolues qui mesurent respectivement des confiances associées auxdites nouvelles estimations, des bits d'information décodés étant extraits de la matrice de décision produite lors de la dernière étape de recherche de mots de code,

et dans lequel chaque étape de recherche de mots de code comporte une division de la matrice de données reçue en vecteurs de données correspondant chacun à un mot de code du code élémentaire et une division correspondante de la matrice de décision reçue en vecteurs de décision et des décodages élémentaires à décisions douces pour traiter respectivement certains au moins des couples vecteur de données/vecteur de décision,

le décodeur comprenant en outre des moyens de programmation pour déterminer, à partir d'un nombre X fourni pour programmer le nombre de bits d'information décodés à extraire de la matrice de décision, X positions uniformément distribuées suivant chaque dimension d'une sous-matrice non redondante de ladite matrice binaire, les moyens de formation de la matrice d'entrée étant agencés pour placer, en des positions correspondant auxdites X positions, des échantillons numériques de signes déterminés et dont les valeurs absolues sont représentatives d'une confiance maximale.

D'autres particularités et avantages de la présente invention apparaîtront dans la description ci-après d'exemples de réalisation non limitatifs, lue conjointement aux dessins annexés, dans lesquels :

- la figure 1 est un schéma synoptique d'une chaîne de transmission numérique utilisable pour mettre en oeuvre le procédé selon l'invention ;
- la figure 2 est un organigramme illustrant l'application d'un code produit ;
- la figure 3 est un organigramme général d'une phase de décodage itératif utilisable selon l'invention ;
- la figure 4 est un organigramme détaillant une étape de décodage élémentaire de ligne ou de colonne ;
- la figure 5 est un graphique illustrant des performances du décodage itératif selon les figures 3 et 4 ;
- les figures 6 et 7 sont des schémas synoptiques respectifs d'un circuit de décodage canal et d'un circuit de codage canal selon l'invention ;
- la figure 8 est un organigramme d'une procédure d'allocation utilisable pour le raccourcissement d'un code produit ;
- la figure 9 est un diagramme illustrant les résultats de la procédure de la figure 8 ;
- la figure 10 est un organigramme d'une procédure d'allocation utilisable pour le poinçonnage d'un code produit ;
- les figures 11 et 12 sont des diagrammes illustrant les résultats de la procédure de la figure 10 ; et
- les figures 13 et 14 sont des graphiques illustrant des performances du décodage itératif appliqué à un code produit raccourci et à un code produit poinçonné.

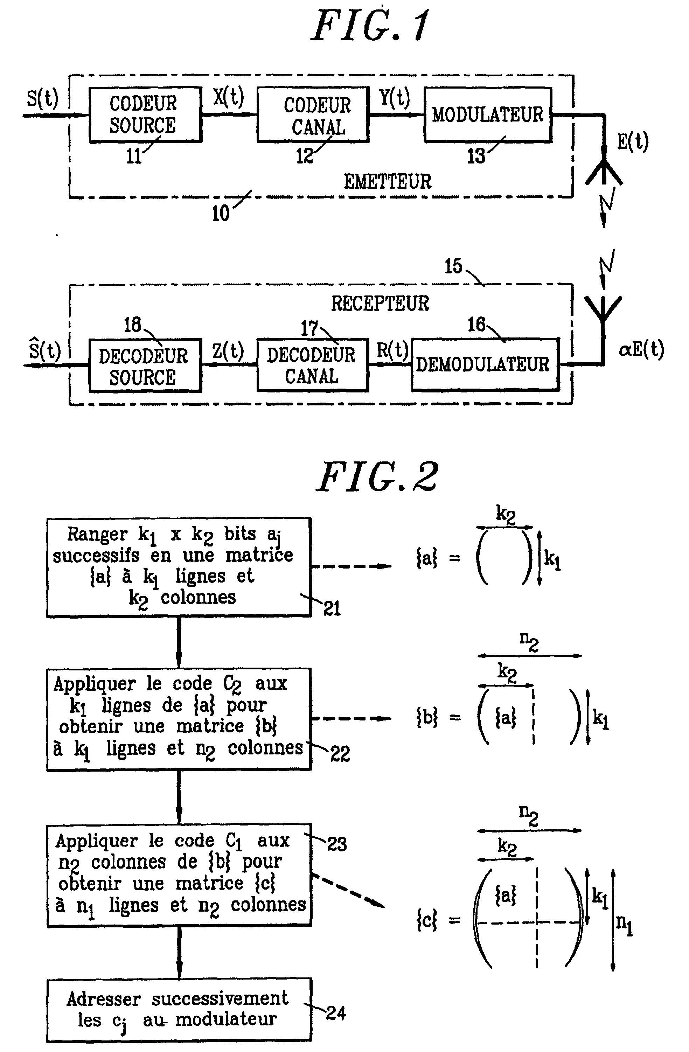

Les inventeurs ont développé une variante avantageuse, assurant un bon compromis performances/complexité, des procédés de décodage itératif de codes produits décrits dans EP-A-0 654 910. Cette variante est décrite ci-après en référence aux figures 1 à 5, avant de décrire plus spécifiquement la structure d'un code produit selon l'invention. On pourra observer que d'une part ladite variante peut s'appliquer au décodage itératif de tout type de code produit, et que d'autre part le procédé de transmission selon l'invention est compatible avec d'autres méthodes de décodage itératif, telles que par exemple celles exposées dans EP-A-0 654 910 ou encore dans l'article précité de J. Lodge et al.

Dans la chaîne de transmission illustrée sur la figure 1, les bits d'information à transmettre $a_j$ sont contenus dans un signal

$$X(t) = \sum_j a_j h(t - jT)$$

adressé à l'entrée du codeur canal 12 de l'émetteur 10. Ce signal $X(t)$ est formé par le codeur source 11 à partir d'un signal analogique $S(t)$. Le codeur source 11 est classiquement tel que les $a_j$ soient indépendants et prennent de manière équiprobable la valeur 0 ou 1. $h(t)$ désigne une porte temporelle de durée $T$ qui est l'intervalle de temps séparant deux bits successifs. Le codeur canal 12 applique un codage en blocs pour produire un signal

$$Y(t) = \sum_j c_j h(t - jT')$$

où les $c_j$ sont les bits codés et $T'$ est l'intervalle de temps séparant deux bits codés ($T' < T$). Le modulateur 13 transforme la séquence $Y(t)$ en séquences de signaux compatibles avec le canal de propagation. Dans le cas d'une modulation de phase à deux états associée à un canal hertzien, un exemple du signal émis est donné par:

$$E(t) = \sum_j e_j h(t - jT_s) \sin(2\pi f_0 t)$$

où $f_0$ est la fréquence de l'onde porteuse et $e_j = 2.c_j - 1$. Le signal reçu au niveau de l'antenne du récepteur 15 est atténué par un coefficient $\alpha$. Le démodulateur 16 élabore le rapport de vraisemblance de chaque bit qui peut s'écrire :

$$R_j = e_j + B_j$$

où les échantillons $B_j$ sont les échantillons de bruit induits par le canal de propagation, indépendants des bits $c_j$, et non-corrélés entre eux, de moyenne nulle et d'écart type o, fonction du rapport signal à bruit. Le signal à la sortie du démodulateur 16 est alors égal à :

$$R(t) = \sum_j R_j h(t - jT')$$

Le décodeur canal 17 prend ensuite la décision concernant les bits émis en exploitant le codage canal utilisé à l'émission pour minimiser les erreurs. Son signal de sortie est donné par :

$$Z(t) = \sum_j \hat{a}_j h(t - jT)$$

où les bits $\hat{a}_j$ sont les décisions prises par le décodeur canal. Le décodeur source 18 reconstruit ensuite le signal analogique S(t) à partir des bits fournis par le décodeur canal 17.

L'invention réside principalement dans le codeur canal 12 et le décodeur canal 17. On comprendra donc qu'elle est compatible avec divers types de codage/décodage source, de modulation/démodulation et de canaux de propagation. En particulier, l'invention peut s'appliquer dans le cadre de la télévision numérique. Le codeur 11 et le décodeur 18 peuvent alors être réalisés selon une norme MPEG (moving picture expert group), par exemple, et le modulateur 13 et le démodulateur 16 sont adaptés au canal de propagation utilisé (hertzien, filaire ....). Un autre exemple d'application est la transmission de télécopies.

Le code en blocs appliqué par le codeur canal 12 est un code produit obtenu à partir de codes élémentaires systématiques. Dans le mode de réalisation décrit ci-après, c'est le produit de deux codes en blocs linéaires $C_1$, $C_2$ de paramètres respectifs $(n_1,k_1,d_1)$ et $(n_2,k_2,d_2)$.

La procédure de codage, réalisée avec des circuits de codage classiques, est illustrée sur la figure 2. Les bits $a_j$ reçus successivement du codeur source 11 sont d'abord rangés, par groupes de $k_1 \times k_2$ bits, selon une matrice {a} à $k_1$ lignes et $k_2$ colonnes (étape 21). Le code en blocs $C_2$ est alors appliqué à chacune des $k_1$ lignes de la matrice {a}, ce qui fournit une matrice {b} à $k_1$ lignes et $n_2$ colonnes (étape 22). Comme le code $C_2$ est systématique, $k_2$ des $n_2$ colonnes de la matrice {b} sont identiques à la matrice (a), par exemple les $k_2$ premières colonnes. Ensuite (étape 23), le code en blocs $C_1$ est appliqué à chacune des $n_2$ colonnes de la matrice {b}, ce qui fournit une matrice {c} à $n_1$ lignes et $n_2$ colonnes dont les composantes $c_j$ sont les bits transmis successivement au modulateur 13 sous la forme du signal Y(t) (étape 24). Comme le code $C_1$ est systématique, $k_1$ des $n_1$ lignes de la matrice {c} sont identiques à la matrice {b}, par exemple les $k_1$ premières lignes. Ainsi, la partie supérieure gauche, de $k_1$ lignes et $k_2$ colonnes, de la matrice {c} est identique à la matrice {a}, les autres composantes de la matrice {c} étant des bits de redondance. Toutes les colonnes de la matrice {c} sont des mots de code du code $C_1$. De même, toutes les lignes de la matrice {c} sont des mots de code du code $C_2$, étant donné que les codes élémentaires sont linéaires.

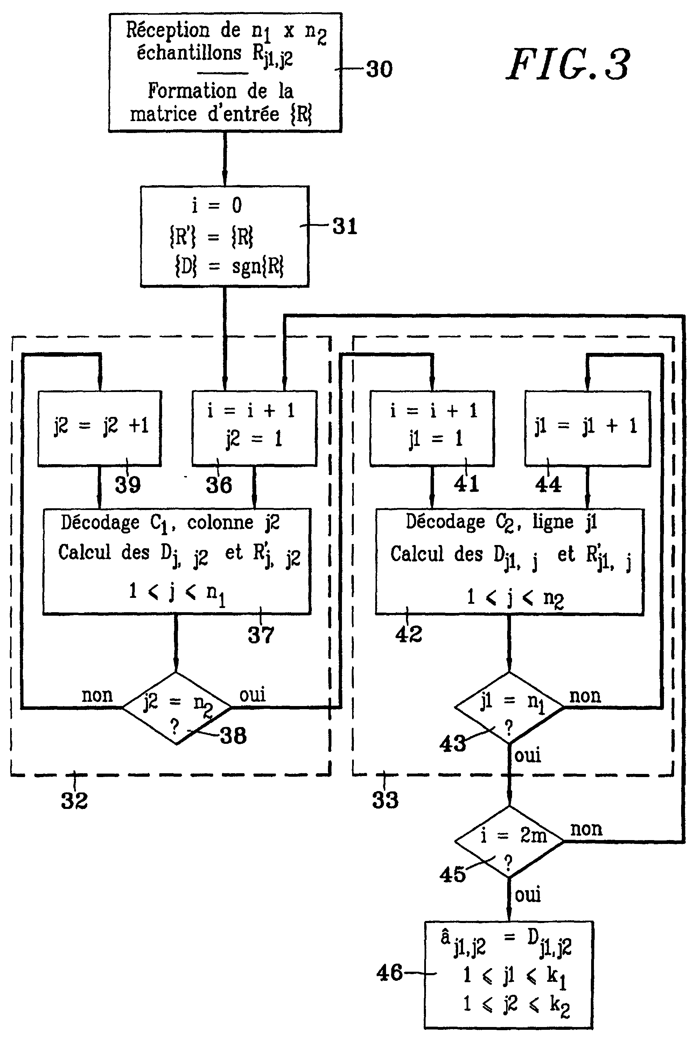

Le décodeur canal 17 applique une procédure de décodage itératif dont l'organigramme général est présenté sur la figure 3. Après réception d'un bloc de $n_1 \times n_2$ échantillons $R_{j1,j2}$ ($1 \le j1 \le n_1$ , $1 \le j2 \le n_2$) du signal R(t) reçu du démodulateur 16, qui correspond à l'émission d'un bloc codé formé par le codeur canal 12, ces échantillons sont rangés dans une matrice d'entrée {R} à $n_1$ lignes et $n_2$ colonnes (étape 30).

Le décodage de ce bloc de $n_1 \times n_2$ échantillons est initialisé (étape 31) en initialisant à 0 la variable de comptage i, en formant une matrice de données {R'} à $n_1$ lignes et $n_2$ colonnes dont les composantes sont initialement les mêmes que celles de la matrice d'entrée {R}, et en formant une matrice de décision {D} à $n_1$ lignes et $n_2$ colonnes dont les composantes sont binaires (-1 ou +1) et, initialement, représentent chacune le signe de la composante correspondante de la matrice d'entrée {R} :

$$D_{j1,j2} = \text{sgn}\,(R_{j1,j2}) = \pm 1.$$

Après cette initialisation, le décodage itératif comporte un nombre m de cycles de décodage. Chaque cycle de décodage comporte successivement une étape 32 de recherche de mots du code $C_1$ dans les colonnes de la matrice de données, et une étape 33 de recherche de mots du code $C_2$ dans les lignes de la matrice de données.

A chaque étape de recherche 32 ou 33, on calcule de nouvelles valeurs des composantes de la matrice de décision {D} et de la matrice de données {R'} qui sont utilisées pour l'étape de recherche suivante. Chaque étape de recherche 32 ou 33 peut être vue comme un filtrage appliqué à la matrice de données {R'} pour réduire l'incidence des échantillons de bruit $B_{j1,j2}$ sur les composantes $R'_{j1,j2}$ de cette matrice.

Les étapes 32 et 33 sont essentiellement identiques si on permute le rôle de lignes et des colonnes des matrices. A l'initialisation 36 de l'étape de recherche 32, la variable de comptage i est incrémentée d'une unité, et l'indice de colonne j2 est initialisé à 1. On effectue un décodage, selon le code $C_1$, du mot de données correspondant à la j2-ième colonne de la matrice {R'} (étape 37), ce qui fournit de nouvelles valeurs des composantes $D_{j,j2}$ et $R'_{j,j2}$ des matrices {D} et {R'} ($1 \le j \le n_1$). L'étape de décodage 37 est suivie par une comparaison 38 entre l'indice de colonne j2 et le nombre de colonnes $n_2$. Lorsque j2 reste inférieur à $n_2$, l'indice j2 est incrémenté d'une unité (étape 39), puis l'étape de décodage 37 est répétée. Lorsque j2 devient égal à $n_2$, toutes les colonnes ayant été traitées, on commence l'autre étape 33 de recherche de mots de code du cycle de décodage en cours. A l'initialisation 41 de l'étape de recherche 33, la variable de comptage i est incrémentée d'une unité, et l'indice de ligne j1 est initialisé à 1. On effectue un décodage, selon le code $C_2$, du mot de données correspondant à la j1-ième ligne de la matrice (R') (étape 42), ce qui fournit de nouvelles valeurs des composantes $D_{j1,j}$ et $R'_{j1,j}$ des matrices {D} et {R'}. L'étape de décodage 42 est suivie par une comparaison 43 entre l'indice de ligne j1 et le paramètre $n_1$ du code $C_1$. Lorsque j1 reste inférieur à $n_1$, l'indice j1 est incrémenté d'une unité (étape 44), puis l'étape de décodage 42 est répétée. Lorsque j1 devient égal à $n_1$, l'étape 33 de recherche de mots de code est terminée, et la variable de comptage i est comparée à 2m (test 45). Lorsque i reste inférieur à 2m, on revient à l'étape de recherche 32 pour commencer le cycle de décodage suivant. Lorsque i devient égal à 2m, les m cycles de décodage ayant été accomplis, on extrait (étape 46) les $k_1 \times k_2$ bits d'information décodés $â_{j1,j2}$ de la matrice de décision {D} produite lors de la dernière étape 33 de recherche de mots de code. Avec les codes systématiques $C_1$, $C_2$ appliqués de la façon décrite plus haut en référence à la figure 2, les $â_{j1,j2}$ peuvent être simplement récupérés dans les $k_1$ premières lignes et les $k_2$ premières colonnes de la matrice {D} : $â_{j1,j2} = D_{j1,j2}$ ($1 \le j1 \le k_1$, $1 \le j2 \le k_2$). Ces $â_{j1,j2}$ sont à valeurs -1 ou +1 ; ils peuvent aisément être convertis pour prendre les valeurs 0 ou 1.

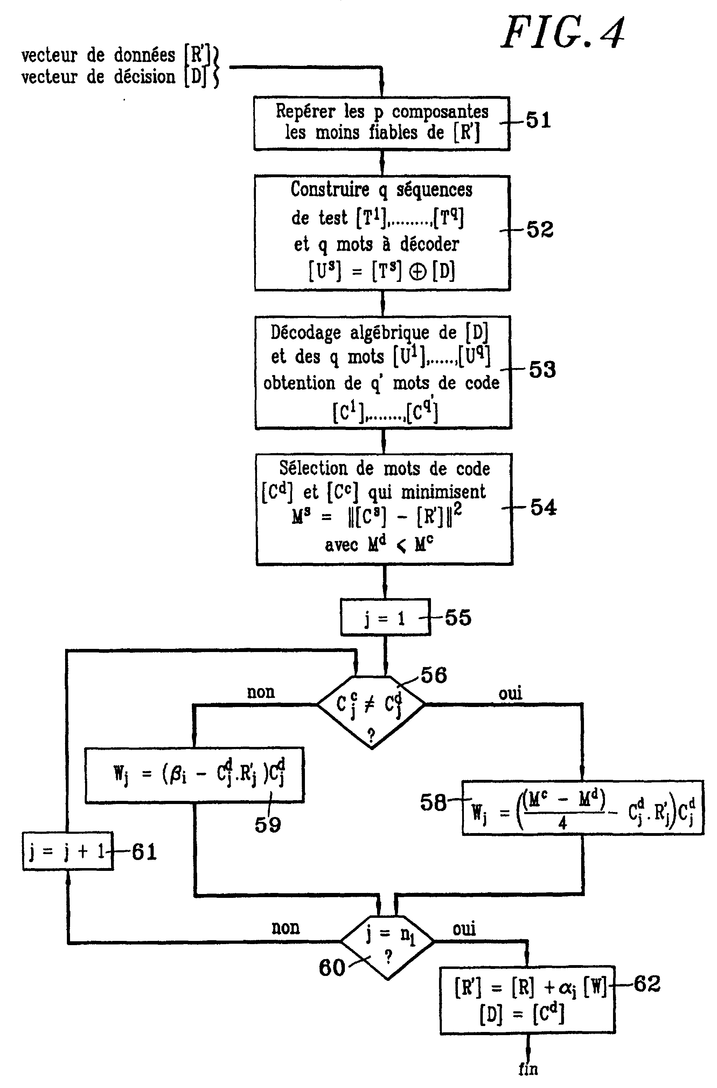

L'étape 37 de décodage d'un mot de données correspondant à une colonne de la matrice de données, dans un premier mode d'exécution de l'invention, est détaillée sur l'organigramme de la figure 4. Lors de cette étape 37, on traite un vecteur de données [R'] et un vecteur de décision [D], de longueur $n_1$, constituant respectivement des subdivisions de la matrice de données {R'} et de la matrice de décision {D} : $R'_j = R'_{j,j2}$ et $D_j = D_{j,j2}$ ($1 \le j \le n_1$). On repère d'abord (étape 51) les p composantes les moins fiables du vecteur [R'], c'est-à-dire les composantes de [R'] qui sont les plus proches du seuil de décision binaire (zéro). Les indices correspondant à ces p composantes les moins fiables sont notés r1, r2, ..., rp, avec

$$|R'_{r1}| < |R'_j| \qquad \forall j \neq r1$$

$$|R'_{r2}| < |R'_j| \qquad \forall j \neq r1, r2 \qquad \text{etc...}$$

Ayant identifié ces p indices, on construit q séquences binaires de test $[T^1],...,[T^q]$ de longueur $n_1$, puis q mots binaires à décoder $[U^1],..., [U^q]$ de longueur $n_1$ en combinant chacune des q séquences de test avec le vecteur de décision [D] (étape 52). On construit chaque mot $[U^s]$ de façon que toutes ses composantes autres que celles correspondant aux p indices r1,...,rp soient égales aux composantes correspondantes du vecteur de décision [D] : $U_j^s = D_j$ pour $j \neq$ r1,...,rp. Il suffit généralement de prendre en compte des mots $[U^s]$ qui n'ont qu'une ou deux composantes différentes des composantes correspondantes du vecteur [D]. Tous ces mots sont pris en compte lorsque q = p(p+1)/2. A titre d'exemple, lorsque p = 6 et q = 21, on peut construire les séquences $[T^S]$ et $[U^S]$ ($1 \le s \le q$) de la façon suivante :

* les p = 6 premières séquences de test $[T^S]$ ont un bit égal à +1 en position rs et des bits égaux à -1 aux autres positions : $T_{rs}^s = +1$ et $T_j^s = -1$ pour $1 \le s \le 6$ et $j \neq$ rs ;

* $[T^7] = [T^1] \oplus [T^2] \qquad [T^{15}] = [T^2] \oplus [T^6]$
  $[T^8] = [T^1] \oplus [T^3] \qquad [T^{16}] = [T^3] \oplus [T^4]$
  $[T^9] = [T^1] \oplus [T^4] \qquad [T^{17}] = [T^3] \oplus [T^5]$
  $[T^{10}] = [T^1] \text{ e } [T^5] \qquad [T^{18}] = [T^3] \oplus [T^6]$
  $[T^{11}] = [T^1] \oplus [T^6] \qquad [T^{19}] = [T^4] \oplus [T^5]$

$[T^{12}] = [T^2] \oplus [T^3]$   $\quad$ $[T^{20}] = [T^4] \oplus [T^6]$
$[T^{13}] = [T^2] \oplus [T^4]$   $\quad$ $[T^{21}] = [T^5] \oplus [T^6]$
$[T^{14}] = [T^2] \oplus [T^5]$

où $\oplus$ désigne l'opération OU exclusif, composante par composante, entre deux vecteurs ;

\*   $[U^s] = [T^s] \oplus [D]$   $\qquad$ pour $1 \leq s \leq q$

A l'étape suivante 53, on effectue un décodage algébrique du vecteur de décision [D] et des q mots [U^s]. Pour ce décodage algébrique, on utilise par exemple, dans le cas de codes BCH, un décodeur de Berlekamp, qui est bien connu dans le domaine du codage par blocs (voir E.R. Berlekamp, "Algebric Coding Theory", M^c Graw-Hill, New-York, 1968). Les q + 1 décodages élémentaires fournissent q' mots de codes $[C^1],...,[C^{q'}]$ du code $C_1$. Dans le cas général, $q' \leq q + 1$, car d'une part certains mots de code peuvent apparaître plusieurs fois dans les résultats des décodages, et d'autre part le décodeur algébrique peut ne pas trouver certains mots de code si le signal est très perturbé. Les mots fournis comme résultats du décodage algébrique doivent donc être vérifiés pour déterminer s'ils constituent ou non des mots du code $C_1$. Cette vérification peut s'effectuer simplement en multipliant chaque mot obtenu par la matrice de vérification de parité relative au code $C_1$ et en éliminant le mot si le résultat de la multiplication n'est pas nul. Toutefois, dans le cas où le code $C_1$ est parfait (c'est-à-dire tel qu'aucun mot de $n_1$ bits n'est éloigné de tous les mots de codes possibles de plus de $(d_1-1)/2$, ce qui est le cas notamment pour les codes de Hamming), l'étape de vérification des résultats du décodeur algébrique est inutile.

Parmi les q' mots de codes trouvés, on sélectionne (étape 54) celui $[C^d]$ qui présente la plus faible distance euclidienne $M^d = \| [C^d] - [R'] \|^2$ avec le vecteur de données [R']. Ce mot $[C^d]$ constituera le prochain vecteur de décision. On sélectionne également, comme mot de code candidat $[C^c]$, celui qui, parmi les q mots de code trouvés à l'exception du mot $[C^d]$, présente la plus faible distance euclidienne $M^c = \| [C^c] - [R'] \|^2$ avec le vecteur de données [R']. Ce mot candidat sera le seul qui pourra être retenu comme mot concurrent pour le calcul des confiances associées aux différents bits du mot $[C^d]$.

On effectue ensuite une boucle de calcul des composantes $W_j$ d'un vecteur de correction [W] ($1 \leq j \leq n_1$). Au début de cette boucle (étape 55), l'indice de composante j est initialisé à 1. A chaque itération dans cette boucle, on effectue une étape de test 56 pour déterminer si la j-ième composante du mot candidat $[C^c]$ est différente de celle du mot de code sélectionné $[C^d]$ ($C_j^c \neq C_j^d$). Dans l'affirmative, le mot de code candidat $[C^c]$ est un mot concurrent relativement à la j-ième composante. La composante $W_j$ est alors calculée à l'étape 58 selon la formule :

$$W_j = \left( \frac{M^c - M^d}{4} - C_j^d \cdot R'_j \right) \cdot C_j^d$$

On observera que la quantité $M^c$-$M^d$ intervenant dans cette formule est toujours positive de sorte que $|M^c - M^d| = M^c - M^d$. Si l'étape de test 56 révèle que $C_j^c = C_j^d$, c'est-à-dire si aucun mot concurrent ne peut être déterminé, la composante $W_j$ est calculée à l'étape 59 selon la formule :

$$W_j = (\beta_i - C_j^d \cdot R'_j) \cdot C_j^d \qquad\qquad (2)$$

où $\beta_i$ désigne un coefficient de confiance positif. Après calcul de la composante de correction $W_j$, l'indice de composante j est comparé à la longueur $n_1$ du vecteur [R'] (étape 60). Lorsque j reste inférieur à $n_1$, l'indice j est incrémenté d'une unité (étape 61), et l'itération suivante est effectuée en commençant par le test 56.

Lorsque j devient égal à $n_1$, la boucle est terminée, et l'étape de décodage 37 se termine par la mise à jour 62 du vecteur de données [R'] et du vecteur de décision [D]. Le nouveau vecteur [R'] est pris égal à la somme du vecteur d'entrée [R] (dont chaque composante $R_j$ est extraite de la matrice d'entrée $\{R\}$ : $R_j = R_{j,j2}$), et du vecteur de correction [W] multiplié par un autre coefficient de confiance positif $\alpha_i$ : $[R'] = [R] + \alpha [W]$. Le nouveau vecteur de décision [D] est pris égal au mot de code $[C^d]$ sélectionné à l'étape 54.

Dans une variante d'exécution, la formule (2) appliquée le cas échéant à l'étape 59 est remplacée par :

$$W_j = \beta_i C_j^d \qquad\qquad (2')$$

qui procure une correction $W_j$ directement proportionnelle au signe de la nouvelle décision $C_j^d$. D'autres formules faisant intervenir un coefficient de confiance pourraient encore être utilisées lorsqu'aucun mot concurrent n'est identifié.

Les étapes 42 de décodage de mots de données correspondant à des lignes de la matrice de données sont semblables aux étapes 37 détaillées ci-dessus en référence à la figure 4, en remplaçant le code $C_1$ par le code $C_2$, et la longueur $n_1$ par la longueur $n_2$, et en divisant les matrices {R'}, {D}, {R} non pas en vecteurs colonnes [R'], [D], [R], mais en vecteurs lignes.

Les coefficients de confiance $\alpha_i$ et $\beta_i$ sont affectés d'un indice qui correspond à la variable de comptage i de l'organigramme de la figure 3. En effet, ces coefficients $\alpha_i$, $\beta_i$ peuvent varier d'une étape de recherche 32, 33 à une autre. De préférence, les $\alpha_i$ et $\beta_i$ croissent au fur et à mesure des étapes de recherche de mots de code 32, 33, pour tenir compte de la fiabilité croissante du décodage.

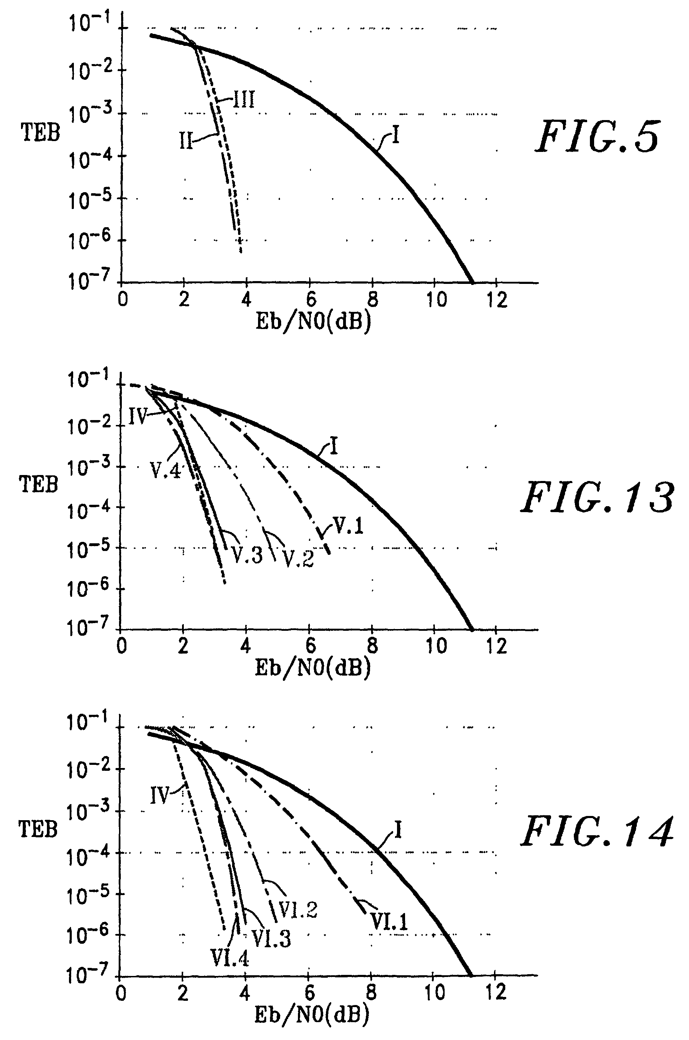

A titre d'illustration des performances du procédé de décodage illustré ci-dessus, la figure 5 montre des courbes de TEB en fonction du rapport signal à bruit Eb/N0 obtenues par simulation dans le cas du produit de deux codes élémentaires identiques BCH(64,57,4). Dans ce cas, le décodeur élémentaire utilisé pour décoder les lignes et les colonnes (étapes 37,42), nécessite environ 43000 portes logiques lorsque le décodage est conforme à la version optimale décrite dans EP-A-0 654 910. Parmi ces 43000 portes, 25000 servent au calcul du vecteur de correction [W], soit 59% du circuit. Avec le décodage élémentaire représenté sur la figure 4, le nombre de portes utiles au calcul de [W] est divisé par 10. Le décodeur élémentaire est donc réalisable avec environ 20500 portes au lieu de 43000. Les résultats de la figure 5 ont été obtenus dans le cas d'une modulation par déplacement de phase à 4 états (QPSK) et d'un canal à bruit blanc additif gaussien, les données étant quantifiées sur 4 bits. On appliquait m=4 cycles de décodage avec q=16 séquences de test construites à partir des p=4 composantes les moins faibles des vecteurs de données [R']. Lors des 2m=8 étapes de recherche de mots de code, les valeurs successives du coefficient $\alpha_i$ étaient 0,4, 0,4, 0,5, 0,5, 0,6, 0,6, 0,65, 0,65, tandis que le coefficient $\beta_i$ restait constant : $\beta_i$=7. La courbe II montre les résultats obtenus en appliquant la version optimale du procédé de décodage selon EP-A-0 654 910. La courbe III montre les résultats correspondants dans le cas du décodage élémentaire selon la figure 4. A titre de comparaison, la courbe I montre les performances observées en l'absence de codage canal. On observe que la dégradation des performances qu'apporte la simplification du décodage élémentaire reste inférieure à 0,15 dB pour un TEB de $10^{-5}$. Cette dégradation est faible si on la met en balance avec le gain de 50% en termes de complexité du circuit. On peut envisager de réaliser un plus grand nombre d'itérations avec le même circuit élémentaire et donc d'apporter une réduction supplémentaire de la complexité globale du circuit.

La figure 6 montre une architecture d'un circuit TCB 17 apte à effectuer le décodage du code produit selon un algorithme tel que celui décrit ci-dessus, dans le cas particulier où les codes élémentaires employés sont identiques. Chacune des étapes de décodage élémentaire selon la figure 4 est exécutée par un circuit arithmétique et logique dédié 65 commandé par un processeur de contrôle 66 du circuit TCB (il serait également possible que plusieurs circuits 65 soient utilisés pour effectuer plusieurs décodages élémentaires en parallèle). Une mémoire RAM 67 est utilisée pour stocker les échantillons des matrices {R}, {R'} et {D}.

Le processeur 66 supervise le décodage selon l'organigramme général de la figure 3. A réception des échantillons du signal R(t), le processeur 66 commande des écritures dans la mémoire 67 pour former la matrice d'entrée {R} (étape 30) et la stocker aux adresses appropriées, et pour construire les matrices {R'} et {D} (étape 31) et les stocker aux adresses appropriées. A chaque décodage élémentaire 37 ou 42, le processeur commande des lectures dans la mémoire 67 pour fournir les échantillons appropriés des vecteurs [R'], [D] et [R] au décodeur élémentaire 65, puis des écritures pour enregistrer les nouvelles valeurs de ces vecteurs [R'] et [D]. A la fin des m cycles, le processeur 66 exécute l'étape 46 en commandant des lectures aux adresses appropriées de la mémoire 67 (matrice {D}) pour délivrer le signal de sortie Z(t) du décodeur 17.

L'invention permet de faire varier divers paramètres du code produit tout en utilisant le même circuit TCB 17 pour le décodage : il suffit simplement de fournir les paramètres appropriés à la partie du programme du processeur 66 qui concerne la formation de la matrice d'entrée {R} à l'étape 30, et éventuellement à celle qui concerne l'extraction des bits d'information à l'étape 46.

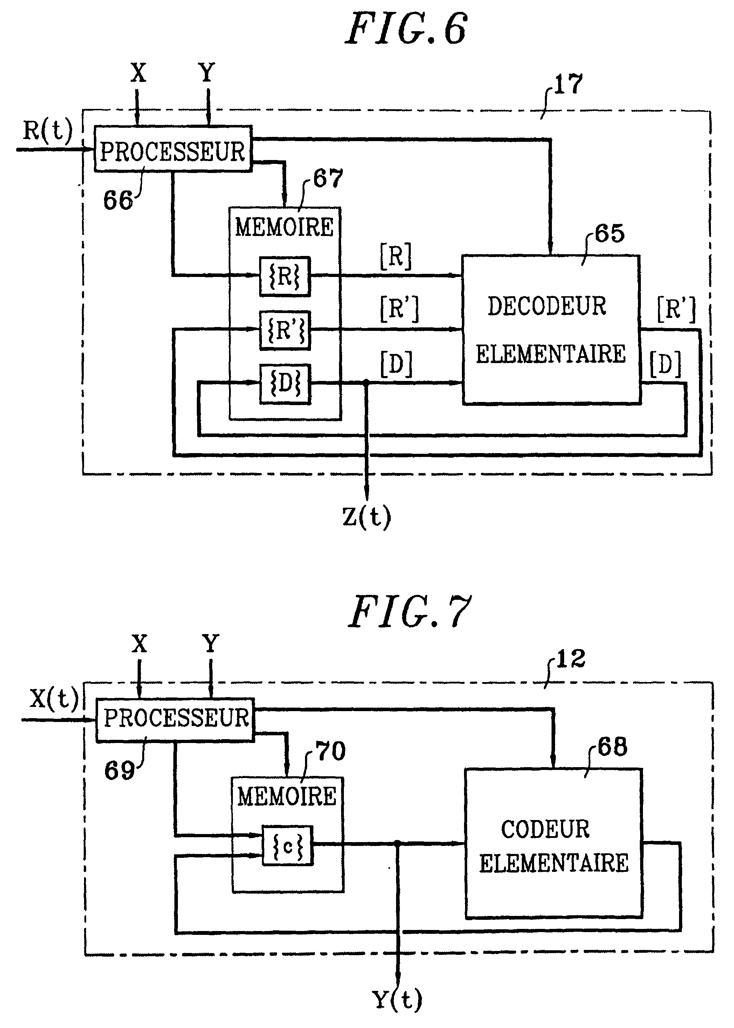

Une programmation intervient également au niveau du codeur 12, dont la figure 7 montre un schéma synoptique dans le cas particulier où les codes élémentaires employés sont identiques. Un circuit arithmétique conventionnel 68 est utilisé pour les codages élémentaires successifs des lignes et des colonnes de la matrice de bits à transmettre (étapes 22 et 23 de la figure 2). Ce codeur élémentaire 68 est commandé par un processeur de contrôle 69 du codeur. Une mémoire RAM 70 est utilisée pour stocker les échantillons de la matrice {c}.

A réception d'un bloc d'échantillons binaires du signal X(t) (notés ici $a_u$ pour u=1,2,...,k-X où k=$k_1.k_2$), le processeur 69 commande des écritures dans la mémoire 70 pour former la matrice {a} à $k_1$ lignes et $k_2$ colonnes, qui est une sous-matrice de la matrice {c} du fait du codage systématique (étape 21). A chaque codage élémentaire, le processeur 69 commande des lectures dans la mémoire 70 pour fournir au codeur 68 les échantillons appropriés de la ligne ou colonne à coder, puis des écritures pour enregistrer les valeurs des bits de redondance obtenus. Après les $n_1+n_2$ codages élémentaires, les bits de la matrice {c} finale sont disponibles dans la mémoire 70, et le processeur 69 commande des lectures aux adresses appropriés dans cette mémoire pour fournir le signal Y(t) au modulateur. Les échantillons binaires du signal Y(t) sont notés ici $c_v$ pour v=1,2,...,n-X-Y où $n=n_1.n_2$.

La programmation du codeur et du décodeur permet d'appliquer une technique de raccourcissement et/ou une technique de poinçonnage au code produit.

Dans le cas du raccourcissement, la programmation consiste à fournir au codeur et au décodeur le nombre X qui représente la différence entre le nombre de bits k de la matrice {a} à laquelle est appliquée le code produit et le nombre k-X de bits $a_u$ par bloc à coder. A partir de ce nombre X, le codeur détermine X positions dans la matrice {a} pour des bits de valeur(s) déterminée(s) (par exemple 0) qui, lors du traitement de chaque bloc, se retrouveront en des positions correspondantes de la matrice {c} et qui seront exclus des bits transmis $c_v$. Il détermine également un ordre dans lequel les bits au de chaque bloc seront rangés aux autres positions de la matrice {a}.

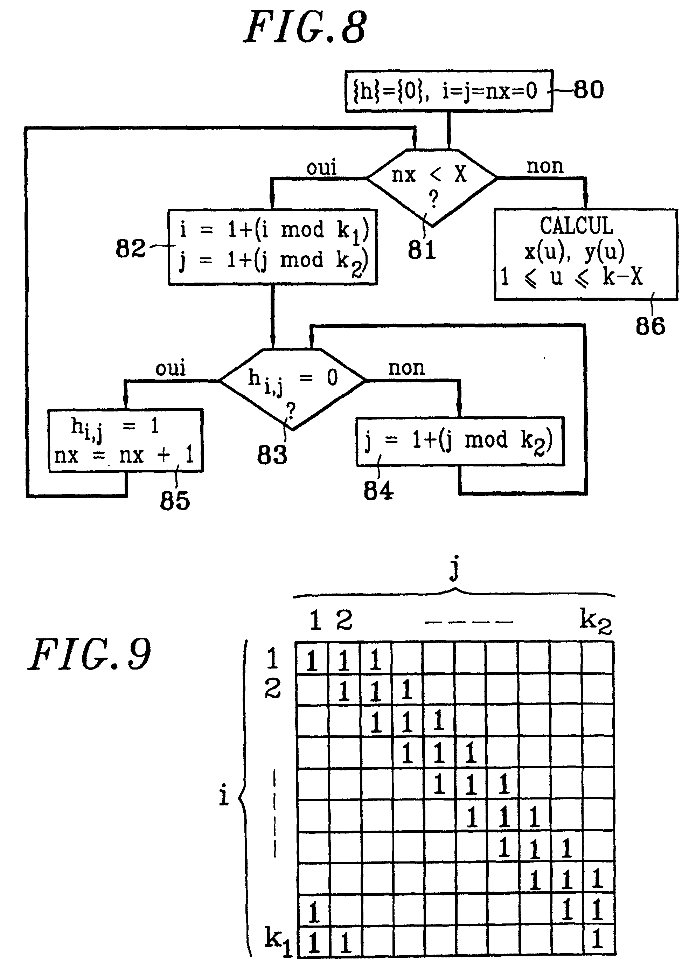

Pour déterminer ces positions, les processeurs 69, 66 du codeur et du décodeur appliquent une procédure prédéfinie, telle que par exemple celle dont l'organigramme est représenté sur la figure 8. Dans cet exemple une matrice {h} à $k_1$ lignes et $k_2$ colonnes désigne, par $h_{i,j}=1$, les positions i,j des bits connus. Initialement, toutes les composantes de la matrice {h} sont à 0, de même que les indices i,j et nx (étape 80). L'indice nx est comparé à X à l'étape 81, et si nx<X, les indices i et j sont incrémentés de 1, respectivement modulo $k_1$ et modulo $k_2$, à l'étape 82 (dans les notations utilisées ici, les indices i et j sont respectivement compris entre 1 et $k_1$ et entre 1 et $k_2$ de sorte que l'incrémentation est effectuée selon les formules indiquées dans le bloc 82 sur la figure 8). Si $h_{i,j}\neq0$ après l'étape 82 (test 83), l'indice de colonne j est incrémenté de 1 modulo $k_2$ à l'étape 84 avant de renouveler le test 83. Lorsque le test 83 montre que $h_{i,j}=0$, la valeur 1 est affectée à cette composante $h_{i,j}$ à l'étape 85, et l'indice nx est incrémenté de 1 avant de revenir à la comparaison 81. Toutes les positions sont affectées lorsque la comparaison 81 montre que nx=X.

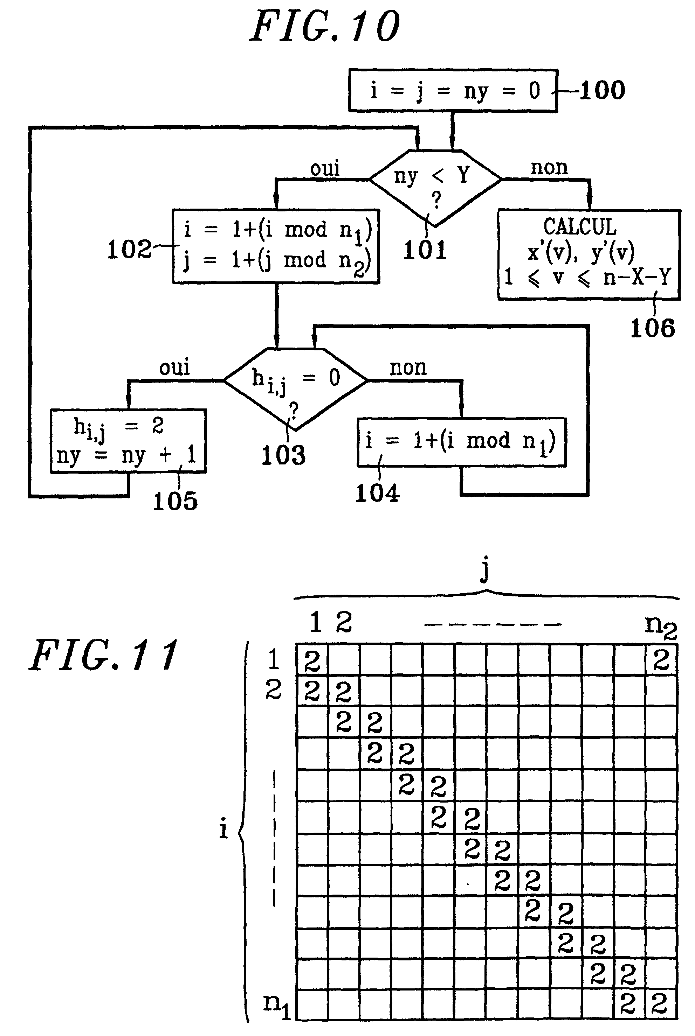

La procédure ci-dessus permet de distribuer uniformément sur les lignes et les colonnes de la matrice {a} les positions des bits connus. L'uniformité est parfaite, c'est-à-dire que toutes les lignes comptent le même nombre de positions $h_{i,j}=1$ de même que toutes les colonnes, lorsque X est un multiple de $k_1$ et de $k_2$ ; sinon, les écarts à l'uniformité sont minimisés. La figure 9 illustre une forme de la matrice {h} dans le cas particulier où $k_1=k_2=10$ et X=30 (les cases vides correspondent à $h_{i,j}=0$).

Après avoir déterminé les X positions où $h_{i,j}=1$, les processeurs 69, 66 calculent chacun deux tableaux x(u), y(u) ($1\leq u\leq k-X$) donnant respectivement les indices de ligne et les indices de colonne des positions de la matrice (a) où seront rangés les bits successifs au de chaque bloc à coder. Ces tableaux sont obtenus à l'étape 86 en affectant dans un ordre déterminé les positions i, j de la matrice {a} telles que $h_{i,j}\neq1$, par exemple ligne après ligne (i=1,2,...,$k_1$) et, dans chaque ligne dans l'ordre croissant des indices de colonne (j=1,2,...,$k_2$).

La procédure de la figure 8 est effectuée une fois lors de la programmation au codeur et du décodeur, les tableaux x(u) et y(u) et la matrice {h} étant ensuite conservés en mémoire. Pour chaque bloc de bits $a_u$, le processeur 69 du codeur 12 construira la matrice {a} à l'étape 21 selon :

$$a_{i,j}=0 \qquad si \qquad h_{i,j}=1$$

$$a_{x(u),y(u)}=a_u \qquad pour \qquad 1\leq u\leq k-X$$

Dans son signal de sortie correspondant à un bloc, le codeur 12 n'inclut pas les bits $c_{i,j}$ tels que $h_{i,j}=1$ (étape 24). En construisant la matrice {R} à l'étape 30, le processeur 66 du décodeur 17 met à ces positions des échantillons $R_{i,j}$ dont le signe correspond à la valeur connue du bit $a_{i,j}$ (par exemple -1 pour $a_{i,j}=0$), et dont la valeur absolue M représente une confiance maximale (typiquement la plus grande des valeurs de quantification du décodeur).

A la fin du décodage du bloc (étape 46), le processeur 66 extrait les estimations $\hat{a}_u$ ($=\pm1$) des bits $a_u$, selon $\hat{a}_u=D_{x(u),y(u)}$.

En ce qui concerne le poinçonnage, la programmation consiste à fournir au codeur et au décodeur le nombre Y qui représente la différence entre le nombre n-X de bits inconnus de la matrice {c} résultant de l'application du code produit (X=0 s'il n'est pas effectué de raccourcissement du code) et le nombre de bits n-X-Y transmis par le codeur pour chaque bloc d'information. A partir de ce nombre Y, le codeur détermine Y positions dans la matrice {c} pour des bits qui seront exclus des bits transmis $c_v$.

Pour déterminer ces positions, les processeurs 69, 66 du codeur et du décodeur appliquent une procédure prédéfinie, telle que par exemple celle dont l'organigramme est représenté sur la figure 10, qui est semblable à celle de la figure 8. Dans cet exemple, on a étendu à $n_1$ lignes et $n_2$ colonnes les dimensions de la matrice {h}, et on désigne par $h_{i,j}=2$, les Y positions i,j des bits poinçonnés. Initialement, toutes les composantes de la matrice (h) sont à 0, sauf celles qui ont été mises à 1 par la procédure de la figure 8 si X≠0, de même que les indices i,j et ny (étape 100). L'indice ny est comparé à Y à l'étape 101, et si ny<Y, les indices i et j sont incrémentés de 1, respectivement modulo $n_1$ et modulo $n_2$, à l'étape 102 (dans les notations utilisées ici, les indices i et j sont respectivement compris entre 1 et $n_1$ et

entre 1 et $n_2$ de sorte que l'incrémentation est effectuée selon les formules indiquées dans le bloc 102 sur la figure 10). Si $h_{i,j} \neq 0$ après l'étape 102 (test 103), l'indice de colonne j est incrémenté de 1 modulo $n_2$ à l'étape 104 avant de renouveler le test 103. Lorsque le test 103 montre que $h_{i,j}=0$, la valeur 2 est affectée à cette composante $h_{i,j}$ à l'étape 105, et l'indice ny est incrémenté de 1 avant de revenir à la comparaison 101. Toutes les positions sont affectées lorsque la comparaison 101 montre que ny=Y.

La procédure ci-dessus permet de distribuer uniformément sur les lignes et les colonnes de la matrice {c} les Y positions des bits poinçonnés. En l'absence de raccourcissement, l'uniformité est parfaite lorsque Y est un multiple de $n_1$ et de $n_2$ ; sinon, les écarts à l'uniformité sont minimisés. La figure 11 illustre une forme de la matrice {h} dans le cas où $n_1=n_2=12$ et Y=24, sans raccourcissement (les cases vides correspondent à $h_{i,j}=0$).

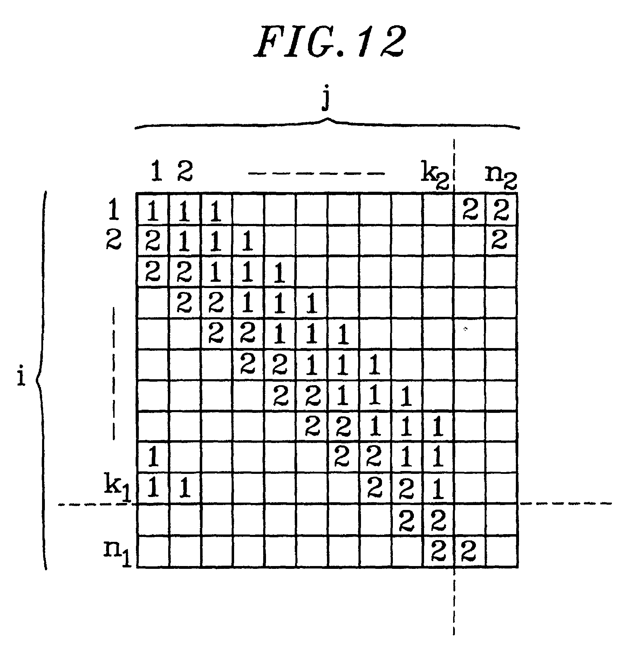

Lorsqu'un raccourcissement est employé conjointement au poinçonnage ($X \neq 0$ et $Y \neq 0$), l'uniformité des Y positions sur les lignes et les colonnes de la matrice {c} est parfaite dans le cas de matrices carrées ($k_1=k_2$ et $n_1=n_2$) si Y est un multiple de $n_1$ ; sinon, les écarts à l'uniformité restent très faibles. La figure 12 illustre une forme de la matrice {h} dans le cas où $k_1=k_2=10$, $n_1=n_2=12$, X=30 et Y=24. Seuls les n-X-Y=90 bits $c_{i,j}$ placés dans les cases vides de la figure 12 sont transmis par le codeur.

La transmission des n-X-Y bits $c_v$ s'effectue dans un ordre déterminé, par exemple ligne après ligne, l'étape 24 consistant alors, pour le codeur, à faire :

$$c_v = c_{x'(v),y'(v)} \qquad \text{pour} \qquad 1 \leq v \leq n\text{-}X\text{-}Y,$$

les indices de ligne et de colonne x'(v), y'(v) étant déterminés et mémorisés au moment de la programmation du codeur et du décodeur, à l'étape 106 (figure 10). De façon correspondante, le processeur 66 du décodeur 17 place les n-X-Y échantillons $R_v$ du bloc de signal reçu aux emplacements appropriés de la matrice {R} à l'étape 30 :

$$R_{x'(v),y'(v)} = R_v \qquad \text{pour} \qquad 1 \leq v \leq n\text{-}X\text{-}Y.$$

Aux autres emplacements, le processeur 66 met :

. $R_{i,j}=-M$ si $h_{i,j}=1$ comme indiqué précédemment,
. $R_{i,j}=\pm\varepsilon$ si $h_{i,j}=2$

Le nombre $\varepsilon$ représente une confiance minimale dans les estimations des Y (typiquement la plus petite des valeurs de quantification du décodeur).

Au cours du décodage itératif, les estimations $D_{i,j}$ des bits tels que $h_{i,j}=1$ resteront très fiables. Celles des bits poinçonnés ($h_{i,j}=2$) verront leurs fiabilités augmenter au fur et à mesure des décodages élémentaires.

Les performances des techniques de raccourcissement et de poinçonnage appliquées à un code produit conformément à l'invention sont illustrées respectivement par les figures 13 et 14 dans le cas du produit de deux codes élémentaires identiques BCH(32,26,4), et d'une modulation par déplacement de phase à 4 états (QPSK). Les paramètres du code produit sont alors :

. k=676
. n=1024
. d=16
. rendement initial 0,660.

Sur les figures 13 et 14, la courbe I montre l'évolution du taux d'erreur binaire (TEB) en fonction du rapport signal/bruit Eb/N0 en l'absence de codage canal, et la courbe IV avec le code produit appliqué sans raccourcissement ni poinçonnage (X=Y=0) et avec un décodage itératif en m=4 cycles.

La figure 13 correspond au cas où X=312, Y=0, c'est-à-dire que chaque bloc à coder se compose de k-X=364 bits d'information et que le rendement de codage est (k-X)/(n-X)=0,511, la limite théorique de Shannon étant alors de 0,04 dB. Les courbes V.1 à V.4 montrent les performances obtenues après, respectivement, m=1, m=2, m=3 et m=4 cycles de décodage. On constate que la pente de la courbe après 4 cycles est pratiquement inchangée par rapport au cas où on transmet k bits d'information par bloc (courbe IV). Le rapport signal à bruit nécessaire pour obtenir un TEB=$10^{-5}$ après 4 cycles est égal à 2,91 dB, ce qui correspond à environ 2,9 dB au-dessus de la limite de Shannon. Cette solution permet de disposer d'un circuit TCB pouvant transmettre des blocs de données de taille quelconque, inférieure ou égale à k, sans dégradation significative des performances du codec par rapport à la limite théorique de Shannon.

La figure 14 correspond au cas où le même circuit TCB est programmé avec X=0, Y=104, c'est-à-dire que chaque bloc codé comporte n-k-Y=244 bits de redondance au lieu de 348, et que le rendement de codage est k/(n-Y) =0,735, la limite théorique de Shannon étant alors de 0,81 dB. Les courbes VI.1 à VI.4 montrent les performances obtenues après, respectivement, m=1, m=2, m=3 et m=4 cycles de décodage, dans le cas où les bits poinçonnés sont choisis parmi les bits de redondance ajoutés par le code produit systématique. On constate que la pente de la courbe après 4 cycles est pratiquement inchangée par rapport au cas où on transmet les n bits de la matrice (courbe IV). Le rapport signal à bruit nécessaire pour obtenir un TEB=$10^{-5}$ après 4 cycles est égal à 3,71 dB ce qui correspond à environ 2,9 dB au-dessus de la limite de Shannon. Cette solution permet de disposer d'un circuit TCB dont le nombre de bits de redondance utilisé est quelconque, inférieur ou égal à n-k, sans dégradation significative des performances du codec par rapport à la limite théorique de Shannon.

## Revendications

1. Procédé pour transmettre des bits d'information, dans lequel un émetteur (10) exécute les étapes suivantes :

   - formation d'une première matrice binaire ({a}) à partir des bits d'information à transmettre ($a_u$) ;
   - transformation de la première matrice binaire en une seconde matrice binaire ({c}) par application d'un code en blocs systématique correspondant au produit de codes en blocs systématiques élémentaires ($C_1$,$C_2$) ; et
   - émission vers un canal de bits ($c_v$) extraits de la seconde matrice binaire,

      et un récepteur (15) exécute les étapes suivantes :

   - formation d'une matrice d'entrée ({R}) à partir d'un signal (R(t)) reçu selon ledit canal, la matrice d'entrée ayant la même taille que la seconde matrice binaire, et se composant d'échantillons numériques dont les signes représentent des estimations initiales respectives des bits de la seconde matrice binaire et dont les valeurs absolues mesurent respectivement des confiances associées auxdites estimations initiales ; et
   - décodage itératif de la matrice d'entrée incluant un nombre m de cycles de décodage, chaque cycle de décodage comportant successivement des étapes (32,33) de recherche des mots de code pour chaque code en blocs élémentaire utilisé dans le code produit,

      dans lequel, à chaque étape (32,33) de recherche de mots de code, on reçoit une matrice de données ({R'}) et une matrice de décision ({D}) à composantes binaires qui, avant la première étape de recherche du décodage itératif, sont respectivement constituées par la matrice d'entrée ({R}) et par une matrice dont les composantes binaires correspondent aux signes des échantillons de la matrice d'entrée, et on produit pour l'étape de recherche suivante une nouvelle matrice de décision ({D}) dont les composantes binaires représentent de nouvelles estimations respectives des bits de la seconde matrice binaire et une nouvelle matrice de données ({R'}) dont les échantillons ont des valeurs absolues qui mesurent respectivement des confiances associées auxdites nouvelles estimations,

      dans lequel les bits d'information décodés ($â_u$) sont extraits de la matrice de décision produite lors de la dernière étape de recherche de mots de code,

      et dans lequel chaque étape (32,33) de recherche de mots de code comporte une division de la matrice de données reçue en vecteurs de données ([R']) correspondant chacun à un mot de code du code élémentaire et une division correspondante de la matrice de décision reçue en vecteurs de décision ([D]) et des décodages élémentaires à décisions douces (37,42) pour traiter respectivement certains au moins des couples vecteur de données/vecteur de décision,

      **caractérisé en ce que** la première matrice binaire ({a}) comporte, en plus des bits d'information ($a_u$), un ensemble de bits de valeurs connues a priori du récepteur, qui sont distribués de façon sensiblement uniforme suivant chaque dimension de la première matrice binaire, qui se retrouvent après le codage systématique en des positions déterminées de ladite seconde matrice binaire ({c}), et qui ne sont pas émis vers le canal, et **en ce que** le récepteur (15) place dans la matrice d'entrée ({R}), en des positions correspondant auxdites positions déterminées de la seconde matrice binaire, des échantillons dont les signes correspondent respectivement aux valeurs connues a priori des bits dudit ensemble et dont les valeurs absolues sont représentatives d'une confiance maximale.

2. Procédé selon la revendication 1, **caractérisé en ce qu'**un autre ensemble de bits ayant d'autres positions déterminées dans la seconde matrice binaire ({c}) ne sont pas émis vers le canal, et **en ce que** le récepteur (15) place dans la matrice d'entrée ({R}), en des positions correspondant auxdites autres positions déterminées de la seconde matrice binaire, des échantillons dont les valeurs absolues sont représentatives d'une confiance minimale.

**3.** Procédé selon la revendication 2, **caractérisé en ce que** lesdites autres positions déterminées sont réparties de façon sensiblement uniforme suivant chaque dimension de la seconde matrice binaire ({c}).

**4.** Procédé selon la revendication 1, 2 ou 3, **caractérisé en ce que** le décodage élémentaire à décisions douces (37,42) pour le traitement d'un couple vecteur de données/vecteur de décision comporte les étapes suivantes :

- détermination d'un nombre p d'indices (r1,...rp) pour lesquels les composantes du vecteur de données ([R']) sont les moins fiables ;
- construction d'un nombre q de mots binaires à décoder ([U$^s$]) à partir desdits p indices et du vecteur de décision ([D]) ;
- obtention de q' mots de code ([C$^s$]) sur la base de décodages algébriques du vecteur de décision et des q mots binaires à décoder ;
- sélection, parmi les q' mots de code obtenus, de celui ([C$^d$]) ayant la plus faible distance euclidienne avec le vecteur de données ([R']) ;
- calcul d'un vecteur de correction ([W]), chaque composante $W_j$ du vecteur de correction étant respectivement calculée en déterminant un éventuel mot concurrent ([C$^c$]) ayant sa j-ième composante différente de celle du mot de code sélectionné ([C$^d$]), et en appliquant la formule :

$$W_j = \left( \frac{|M^c - M^d|}{4} - C_j^d \cdot R_j' \right) C_j^d$$

lorsqu'un mot concurrent a été déterminé, $M^d$ et $M^c$ désignant respectivement les distances euclidiennes, par rapport au vecteur de données ([R']), du mot de code sélectionné ([C$^d$]) et du mot concurrent ([C$^c$]), et $C_j^d$ et $R_j'$ désignant respectivement les j-ièmes composantes du mot de code sélectionné et du vecteur de données ;
- obtention du nouveau vecteur de décision ([D]) pris égal audit mot de code sélectionné ([C$^d$]); et
- calcul du nouveau vecteur de données ([R']) en ajoutant le vecteur de correction ([W]) multiplié par un premier coefficient de confiance ($\alpha_i$) au vecteur d'entrée correspondant ([R]) extrait de la matrice d'entrée ({R}).

**5.** Procédé selon la revendication 4, **caractérisé en ce que**, dans l'étape de calcul d'un vecteur de correction ([W]), la détermination d'un éventuel mot concurrent ([C$^c$]) relativement à la j-ième composante du mot de code sélectionné ([C$^d$]) comprend une comparaison entre la j-ième composante du mot de code sélectionné ([C$^d$]) et celle d'un mot de code candidat qui, parmi les q' mots de code obtenus à l'exception du mot de code sélectionné, a la plus faible distance euclidienne avec le vecteur de données ([R']), ledit mot de code candidat étant pris comme mot concurrent lorsque sa j-ième composante est différente de celle du mot de code sélectionné, et aucun mot concurrent n'étant déterminé dans le cas contraire.

**6.** Procédé selon la revendication 4 ou 5, **caractérisé en ce que** le calcul de chaque composante $W_j$ du vecteur de correction ([W]) en l'absence de détermination d'un mot concurrent relativement à cette composante est effectué selon la formule :

$$W_j = \beta_i C_j^d$$

où $\beta_i$ désigne un second coefficient de confiance.

**7.** Procédé selon la revendication 4 ou 5, **caractérisé en ce que** le calcul de chaque composante $W_j$ du vecteur de correction ([W]) en l'absence de détermination d'un mot concurrent relativement à cette composante est effectué selon la formule :

$$W_j = (\beta_i - C_j^d R_j')C_j^d$$

où $\beta_i$ désigne un second coefficient de confiance.

8. Codeur à redondance (12), comportant :

- des moyens (69) pour former une première matrice binaire ({a}) à partir de bits d'information à transmettre ($a_u$) ;
- des moyens de codage élémentaire (68) commandés pour transformer la première matrice binaire en une seconde matrice binaire ({c}) par application d'un code en blocs systématique correspondant au produit de codes en blocs systématiques élémentaires ($C_1, C_2$); et
- des moyens pour émettre vers un canal des bits ($c_v$) extraits de la seconde matrice binaire,

**caractérisé en ce qu'**il comprend en outre des moyens de programmation (69) pour déterminer, à partir d'un nombre X fourni pour programmer le nombre de bits d'information à inclure dans chaque première matrice, X positions uniformément distribuées suivant chaque dimension de la première matrice, et **en ce que** les moyens de formation de la première matrice sont agencés pour placer des bits de valeurs connues auxdites X positions, lesdits bits de valeurs connues se retrouvant après le codage systématique en des positions déterminées de la seconde matrice binaire et n'étant pas émis vers le canal.

9. Codeur selon la revendication 8, **caractérisé en ce que** les moyens de programmation (69) sont agencés pour déterminer, à partir d'un nombre Y fourni pour programmer le nombre de bits de la seconde matrice émis vers le canal, Y positions dans la seconde matrice ({c}), et **en ce que** les bits de la seconde matrice qui se trouvent auxdites Y positions ne sont pas émis vers le canal.

10. Codeur selon la revendication 9, **caractérisé en ce que** les moyens de programmation (69) distribuent lesdites Y positions de façon sensiblement uniforme suivant chaque dimension de la seconde matrice binaire ({c}).

11. Décodeur correcteur d'erreurs (17), comportant :

- des moyens (66) pour former une matrice d'entrée ({R}) à partir d'un signal (R(t)) reçu selon un canal de transmission, la matrice d'entrée se composant d'échantillons numériques dont les signes représentent des estimations initiales respectives de bits d'une matrice binaire formée par un codeur à redondance (12) appliquant un code en blocs systématique correspondant au produit de codes en blocs systématiques élémentaires ($C_1, C_2$), et dont les valeurs absolues mesurent respectivement des confiances associées auxdites estimations initiales ; et
- des moyens (65) de décodage itératif commandés pour décoder la matrice d'entrée suivant des cycles de décodage successifs, chaque cycle de décodage comportant successivement des étapes (32,33) de recherche des mots de code pour chaque code en blocs élémentaire utilisé dans le code produit,

dans lequel, à chaque étape (32,33) de recherche de mots de code, les moyens de décodage (65) reçoivent une matrice de données ({R'}) et une matrice de décision ({D}) à composantes binaires qui, avant la première étape de recherche, sont respectivement constituées par la matrice d'entrée ({R}) et par une matrice dont les composantes binaires correspondent aux signes des échantillons de la matrice d'entrée ({R}), et produisent pour l'étape de recherche suivante une nouvelle matrice de décision ({D}) dont les composantes binaires représentent de nouvelles estimations respectives des bits de la seconde matrice binaire et une nouvelle matrice de données ({R'}) dont les échantillons ont des valeurs absolues qui mesurent respectivement des confiances associées auxdites nouvelles estimations, des bits d'information décodés ($\hat{a}_u$) étant extraits de la matrice de décision produite lors de la dernière étape de recherche de mots de code, et dans lequel chaque étape (32,33) de recherche de mots de code comporte une division de la matrice de données reçue en vecteurs de données ([R']) correspondant chacun à un mot de code du code élémentaire et une division correspondante de la matrice de décision reçue en vecteurs de décision ([D]) et des décodages élémentaires à décisions douces (37,42) pour traiter respectivement certains au moins des couples vecteur de données/vecteur de décision, **caractérisé en ce qu'**il comprend en outre des moyens de programmation (66) pour déterminer, à partir d'un nombre X fourni pour programmer le nombre de bits d'information décodés à extraire de la matrice de décision, X positions uniformément distribuées suivant chaque dimension d'une sous-matrice non redondante ({a}) de ladite matrice binaire, et **en ce que** les moyens de formation de la matrice d'entrée ({R}) sont agencés pour placer, en des positions correspondant auxdites X positions, des échantillons numériques de signes déterminés et dont les valeurs absolues sont représentatives d'une confiance maximale.

**12.** Décodeur selon la revendication 11, **caractérisé en ce que** les moyens de programmation (66) sont agencés pour déterminer, à partir d'un nombre Y fourni pour programmer le nombre d'échantillons de la matrice d'entrée obtenus à partir du signal reçu, Y positions dans la matrice d'entrée ({R}), et **en ce que** les moyens de formation de la matrice d'entrée sont agencés pour placer auxdites Y positions des échantillons numériques dont les valeurs absolues sont représentatives d'une confiance minimale.

**13.** Décodeur selon la revendication 12, **caractérisé en ce que** les moyens de programmation (66) distribuent lesdites Y positions de façon sensiblement uniforme suivant chaque dimension de la matrice d'entrée ({R}).

**Claims**

**1.** Process for transmitting information bits, in which a transmitter (10) executes the following steps:

- formation of a first binary matrix ({a}) from the information bits to be transmitted ($a_u$);
- conversion of the first binary matrix into a second binary matrix ({c}) by application of a systematic block code corresponding to the product of elementary systematic block codes ($c_1,c_2$); and
- transmission of the bits ($c_v$)extracted from the second binary matrix towards a channel,

   and a receiver (15) executes the following steps:

- formation of an input matrix ({R}) from a signal (R(t)) received according to the said channel, the input matrix being of the same size as the second binary matrix, and being comprised of digital samples the signs of which represent respective initial estimations of the bits in the second binary matrix and the absolute values of which respectively measure the confidences associated with the said initial estimations; and
- iterative decoding of the input matrix including a number m of decoding cycles, each decoding cycle successively comprising code word search steps (32,33) for each elementary block code used in the product code,

   in which, at each code word search step (32,33), a data matrix ({R'}) and a decision matrix ({D}) with binary components are received which, before the first search step for the iterative decoding, are respectively constituted by the input matrix ({R})and by the matrix the binary components of which correspond to the signs of the input matrix samples, and for the following search step a new decision matrix ({D}) is produced, the binary components of which represent new respective estimations of the bits of the second binary matrix and a new data matrix ({R'}) the samples of which have absolute values which respectively measure confidences associated with the said new estimations,
   in which decoded information bits ($â_u$) are extracted from the decision matrix produced during the last code word search step,
   and in which each code word search step (32,33) includes a division of the data matrix received into data vectors ([R']) each corresponding to a code word of the elementary code and a corresponding division of the decision matrix received into decision vectors ([D]) and elementary decodings with soft decisions (37,42) to respectively process at least certain data vector/decision vector pairs.
   **characterised in that** the first binary matrix ({a}) comprises, in addition to the information bits ($a_u$), a set of bits with values a priori known to the receiver, which are distributed in an approximately uniform manner according to each dimension of the first binary matrix, which, after systematic coding, are located in determined positions of the said second binary matrix ({c}), and which are not transmitted towards the channel, and that the receiver (15) places in the input matrix ({R}), in positions corresponding to the said determined positions of the second binary matrix, samples the signs of which correspond respectively to the a priori known values of the bits of the said set and the absolute values of which are representative of a maximum confidence.

**2.** Process according to claim 1, **characterised in that** another set of bits having other determined positions in the second binary matrix ((c)) are not transmitted towards the channel, and **in that** the receiver (15) places in the input matrix ({R}), in positions corresponding to the said other determined positions of the second binary matrix, samples the absolute values of which are representative of minimum confidence.

**3.** Process according to claim 2, **characterised in that** the said other determined positions are distributed approximately uniformly according to each dimension of the second binary matrix ({c}).

**4.** Process according to claim 1, 2 or 3, **characterised in that** the soft decision elementary decoding (37,42) for the processing of a data vector/decision vector pair comprises the following steps:

- determination of a number p of indexes (r1,... rp) for which the data vector components ([R']) are the least reliable;
- construction of a number q of binary words to be decoded ([U$^s$]) from the said p indexes and from the decision vector ([D]);
- obtaining q' code words ([C$^s$]) on the basis of algebraic decodings of the decision vector and the q binary words to be decoded;
- selection, from the q' code words obtained, of that ([C$^d$]) having the shortest euclidean distance with the data vector ([R']);
- calculation of a correction vector ([w]), each component W$_j$ of the correction vector being respectively calculated by determining an optional concurrent word ([C$^c$]) having its j-th component different from that of the selected code word ([C$^d$]), by applying the formula:

$$W_j = \left( \frac{|M^c - M^d|}{4} - C_j^d . R_j' \right) C_j^d$$

when a concurrent word has been determined, M$^d$ and M$^c$ respectively designating the euclidean distances, with respect to the data vector ([R']), of the selected code word ([C$^d$]) and of the concurrent word ([C$^c$]), and C$_j^d$ and R$_j'$ respectively designate the j-th components of the selected code word and of the data vector;
- obtaining the new decision vector ([D]) taken as equal to the said selected code word ([C$^d$]); and
- calculation of the new data vector ([R']) by adding the correction vector ([W]) multiplied by a first confidence coefficient ($\alpha_i$) to the corresponding input vector ([R]) extracted from the input matrix ({R}).

5. Process according to claim 4 **characterised in that**, in the calculation step for a correction vector ([W]), the determination of an optional concurrent word ([C$^c$]) with respect to the j-th component of the selected code word ([C$^d$]) includes a comparison between the j-th component of the selected code word ([C$^d$]) and that of a candidate code word which, among the q' code words obtained except for the selected code word, has the shortest euclidean distance with the data vector ([R']), the said candidate code word being taken as a concurrent word when its j-th component is different from that of the selected code word, and no concurrent word being determined if not.

6. Process according to claim 4 or 5, **characterised in that** the calculation of each component W$_j$ of the correction vector ([W]) in the absence of determination of a concurrent word with respect to that component is carried out according to the formula:

$$W_j = \beta_i C_j^d$$

where $\beta_i$ designates a second confidence coefficient.

7. Process according to claim 4 or 5, **characterised in that** the calculation of each component W$_j$ of the correction vector ([W]) in the absence of determination of a concurrent word with respect to that component is carried out according to the formula:

$$W_j = (\beta_i - C_j^d R_j') C_j^d$$

where $\beta i$ designates a second confidence coefficient.

8. Redundancy coder (12), comprising:

- means (69) to form a first binary matrix ({a}) from information bits to be transmitted (a$_u$);
- elementary coding means (68) instructed to convert the first binary matrix into a second binary matrix ({c}) by application of a systematic block code corresponding to the product of elementary systematic block codes (C$_1$,C$_2$); and

- means to transmit the bits ($c_v$) extracted from the second binary matrix towards a channel,

**characterised in that** it also comprises programming means (69) in order to determine, from a number X supplied to program the number of information bits to be included in each first matrix, X positions uniformly distributed according to each dimension of the first matrix, and **in that** the means for creating the first matrix are designed to place bits of known values in the said X positions, the said bits of known values being located after systematic coding in determined positions of the second binary matrix and not being transmitted towards the channel.

9. Coder according to claim 8, **characterised in that** the programming means (69) are designed to determine, from a number Y supplied in order to program the number of bits of the second matrix transmitted towards the channel, Y positions in the second matrix ({c}), and **in that** the bits of the second matrix located at the said Y positions are not transmitted towards the channel.

10. Coder according to claim 9, **characterised in that** the programming means (69) distribute the said Y positions in an approximately uniform manner according to each dimension of the second binary matrix ({c}).

11. Error correction decoder (17), comprising:

- means (66) for forming an input matrix ({R}) from a signal (R(t)) received according to a transmission channel, the input matrix being composed of digital samples the signs of which represent respective initial estimations of bits of a binary matrix formed by a redundancy coder (12) applying a systematic block code corresponding to the product of elementary systematic block codes ($c_1, c_2$) and the absolute values of which respectively measure the confidences associated with the said initial estimations; and
- iterative decoding means (65) instructed to decode the input matrix according to successive decoding cycles, each decoding cycle successively comprising steps (32,33) for searching code words for each elementary block code used in the product code,

in which, at each code word search step. (32,33), the decoding means (65) receive a data matrix ({R'}) and a decision matrix ({D}) with binary components which, before the first search step for the iterative decoding, are respectively constituted by the input matrix ({R}) and a matrix the binary components of which correspond to the signs of the input matrix ({R}) samples, and for the following search step a new decision matrix ({D}) is produced, the binary components of which represent new respective estimations of the bits of the second binary matrix and a new data matrix ({R'}) the samples of which have absolute values which respectively measure confidences associated with the said new estimations, decoded information bits ($\hat{a}_u$) being extracted from the decision matrix produced during the last step of the code word search,

and in which each code word search step (32,33) includes a division of the data matrix received into data vectors ([R']) each corresponding to a code word of the elementary code and a corresponding division of the decision matrix received into decision vectors ([D]) and elementary decodings with soft decisions (37,42) to respectively process at least certain data vector/decision vector pairs,

**characterised in that** it further comprises programming means (66) to determine, from a number X supplied to program the number of decoded information bits to be extracted from the decision matrix, X positions uniformly distributed according to each dimension of a non-redundant sub-matrix ({a}) of the said binary matrix, and **in that** the means for forming the input matrix ({R}) are designed to place, in positions corresponding to the said X positions, digital samples of determined signs and the absolute values of which are representative of maximum confidence.

12. Decoder according to claim 11, **characterised in that** the programming means (66) are designed to determine, from a number Y supplied in order to program the number of samples of the input matrix obtained from the signal received, Y positions in the input matrix ({R}), and **in that** the means of forming the input matrix are designed to place in the said Y positions digital samples the absolute values of which are representative of maximum confidence.

13. Decoder according to claim 12, **characterised in that** the programming means (66) distribute the said Y positions in an approximately uniform manner according to each dimension of the input matrix ({R}).

**Patentansprüche**

1. Verfahren zur Übertragung von Datenbits, bei dem ein Sender (10) folgende Schritte ausführt:

   - Bildung einer ersten Binärmatrix ({a}) auf der Grundlage von zu übertragenden Datenbits ($a_u$);
   - Umwandlung der ersten Binärmatrix in eine zweite Binärmatrix ({c}) durch Anwendung eines systematischen Blockcodes, der dem Produkt aus systematischen Elementar-Blockcodes entspricht ($C_1, C_2$); und
   - Senden von aus der zweiten Binärmatrix extrahierten Bits ($c_v$) zu einem Kanal,

   und ein Empfänger (15) folgende Schritte ausführt:

   - Bildung einer Eingangsmatrix ({R}) aus einem Signal (R(t)), das auf dem Kanal empfangen wurde, wobei die Eingangsmatrix die gleiche Größe hat wie die zweite Binärmatrix und sich aus digitalen Abtastwerten zusammensetzt, deren Vorzeichen jeweilige initiale Schätzungen der Bits der zweiten Binärmatrix darstellen und deren absolute Werte jeweils Konfidenzen messen, die den initialen Schätzungen zugeordnet werden; und
   - iterative Decodierung der Eingangsmatrix, die eine Anzahl m von Decodierzyklen einschließt, wobei jeder Decodierzyklus nacheinander Schritte (32, 33) der Suche nach Codeworten für jeden Elementar-Blockcode umfasst, der bei dem erzeugten Code verwendet wird,

   bei dem man bei jedem Schritt (32,33) der Suche nach Codeworten eine Datenmatrix ({R'}) und eine Entscheidungsmatrix ({D}) mit Binärkomponenten empfängt, die vor dem ersten Suchschritt des iterativen Decodierens jeweils von der Eingangsmatrix ({R}) und einer Matrix gebildet werden, deren Binärkomponenten den Vorzeichen der Abtastwerte der Eingangsmatrix entsprechen, und man für den folgenden Suchschritt eine neue Entscheidungsmatrix ({D}) erzeugt, deren Binärkomponenten neue jeweilige Schätzungen der Bits der zweiten Binärmatrix und eine neue Datenmatrix ({R'}) darstellen, deren Abtastwerte absolute Werte haben, die jeweils Konfidenzen messen, die den neuen Schätzungen zugeordnet werden,
   bei dem die decodierten Datenbits ($a_u$) aus der beim letzten Codewortsuchschritt erzeugten Entscheidungsmatrix extrahiert werden,
   und bei dem jeder Schritt (32,33) der Suche nach Codeworten eine Teilung der empfangenen Datenmatrix in Datenvektoren ([R']) umfasst, die jeweils einem Codewort des Elementarcodes entspricht, und eine entsprechende Teilung der empfangenen Entscheidungsmatrix in Entscheidungsvektoren ([D]), und Elementardecodierungen mit weichen Entscheidungen (37,42) zur Verarbeitung jeweils zumindest bestimmter Datenvektor-Datenentscheidungs-Paare,
   **dadurch gekennzeichnet, dass** die erste Binärmatrix ({a}) zusätzlich zu den Datenbits ($a_u$) ein Bündel Bits mit dem Empfänger a priori bekannten Werten umfasst, die in im Wesentlichen einheitlicher Form entsprechend jeder Dimension der ersten Binärmatrix verteilt sind, die sich nach der systematischen Codierung an bestimmten Positionen der zweiten Binärmatrix ({c}) wiederfinden, und die nicht zum Kanal gesandt werden, und dadurch, dass der Empfänger (15) in der Eingangsmatrix ({R}) an Positionen, die den genannten festgelegten Positionen der zweiten Binärmatrix entsprechen, Abtastwerte platziert, deren Vorzeichen jeweils den a priori bekannten Werten der Bits des Bündels entsprechen und deren absolute Werte repräsentativ für eine maximale Konfidenz sind.

2. Verfahren nach Anspruch 1, **dadurch gekennzeichnet, dass** ein weiteres Bündel Bits mit anderen bestimmten Positionen in der zweiten Binärmatrix ({c}) nicht zum Kanal gesandt wird, und dadurch, dass der Empfänger (15) in der Eingangsmatrix ({R}) an Positionen, die den anderen bestimmten Positionen der zweiten Binärmatrix entsprechen, Abtastwerte platziert, deren absolute Werte repräsentativ für eine maximale Konfidenz sind.

3. Verfahren nach Anspruch 2, **dadurch gekennzeichnet, dass** die anderen bestimmten Positionen gemäß jeder Demension der zweiten Binärmatrix ({c}) im Wesentlichen einheitlich verteilt sind.

4. Verfahren nach Anspruch 1, 2 oder 3, **dadurch gekennzeichnet, dass** die elementare Decodierung mit weichen Entscheidungen (37,42) für die Verarbeitung eines Datenvektor-Entscheidungsvektor-Paars folgende drei Schritte umfasst:

   - Bestimmung einer Anzahl p von Indizes (r1, ...rp), für welche die Komponenten des Datenvektors ([R']) am wenigsten zuverlässig sind;
   - Darstellung einer Anzahl q zu decodierender Binärworte ([$U^s$]) aus den P Indizes und dem Entscheidungsvektor ([D]);
   - Erhalt von q' Codewörtern ([$C^s$]) auf der Basis von algebraischen Decodierungen des Entscheidungsvektors und der q zu decodierenden Binärworte;

- aus den q' erhaltenen Codewörtern Auswahl desjenigen ($[C^d]$) mit der geringsten euklidischen Distanz zum Datenvektor ($[R']$);
- Berechnung eines Korrekturvektors ($[W]$), wobei jede Komponente $W_j$ des Korrekturvektors jeweils berechnet wird, indem man ein mögliches Konkurrenzwort ($[C^c]$) errechnet, dessen seine j-te Komponente sich von der des ausgewählten Codeworts ($[C^d]$) unterscheidet, und indem man folgende Formel anwendet:

$$W_j = \left( \frac{|M^c - M^d|}{4} - C_j^d \cdot R_j' \right) C_j^d$$

wenn ein Konkurrenzwort festgestellt wurde, wobei Md und Mc jeweils die euklidischen Distanzen des ausgewählten Codeworts ($[C^d]$) und des Konkurrenzworts ($[C^c]$) bezogen auf den Datenvektor ($[R']$) und $C_j^d$ und $R'_j$ jeweils die j-ten Komponenten des ausgewählten Codeworts und des Datenvektors bezeichnen;
- Erhalt des neuen Entscheidungsvektors ($[D]$), der gleich dem ausgewählten Codewort ($[C^d]$) genommen wird; und
- Berechnung des neuen Datenvektors ($([R']$) durch Hinzurechnen des mit einem ersten Konfidenzkoeffizienten ($\alpha_i$) multiplizierten Korrekturvektors ($[W]$) zum entsprechenden, aus der Eingangsmatrix ($\{R\}$) extrahierten Eingangsvektor ($[R]$).

5. Verfahren nach Anspruch 4, **dadurch gekennzeichnet, dass** in dem Schritt der Berechnung eines Korrekturvektors ($[W]$) die Bestimmung eines eventuellen Konkurrenzwortes ($[C^c]$) bezogen auf die j-te Komponente des ausgewählten Codeworts ($[C^d]$) einen Vergleich zwischen der j-ten Komponente des ausgewählten Codeworts ($[C^d]$) und der eines möglichen Codeworts umfasst, das von den q' erhaltenen Codeworten - mit Ausnahme des ausgewählten Codeworts - die geringste euklidische Distanz zum Datenvektor ($[R']$) hat, wobei das mögliche Codewort als Konkurrenzwort genommen wird, wenn seine j-te Komponente sich von derjenigen des ausgewählten Codeworts unterscheidet und wobei im gegenteiligen Fall kein Konkurrenzwort bestimmt wird.

6. Verfahren nach Anspruch 4 oder 5, **dadurch gekennzeichnet, dass** die Berechnung jeder Komponente $W_j$ des des Korrekturvektors ($[W]$) bei Nichtbestimmung eines Konkurrenzworts bezüglich dieser Komponente nach folgender Formel erfolgt:

$$W_j = \beta_i C_j^d$$

wobei $\beta_i$ einen zweiten Konfidenzkoeffizienten bezeichnet.

7. Verfahren nach Anspruch 4 oder 5, **dadurch gekennzeichnet, dass** die Berechnung jeder Komponente Wj des Korrekturvektors ($[W]$) bei Nichtbestimmung eines Konkurrenzworts bezogen auf diese Komponente entsprechend folgender Formel erfolgt:

$$W_j = (\beta_i - C_j^d R_j^{'}) C_j^d$$

wobei $\beta_i$ einen zweiten Konfidenzkoeffizienten bezeichnet.

8. Redundanzcodierer (12), der umfasst:

- Mittel (69) zur Bildung einer ersten Binärmatrix ($\{a\}$) auf der Grundlage von zu übertragenden Datenbits ($a_u$);
- Mittel zur Elementarcodierung (68), die so gesteuert sind, dass sie die erste Binärmatrix in eine zweite Binärmatrix ($\{c\}$) umwandeln, durch Anwendung eines systematischen Blockcodes, der dem Produkt aus systematischen Elementar-Blockcodes entspricht ($C_1, C_2$); und
- Mittel zum Senden von aus der zweiten Binärmatrix extrahierten Bits ($c_v$) zu einem Kanal,

**dadurch gekennzeichnet, dass** es ferner Mittel zur Programmierung (69) umfasst, mit denen ausgehend von einer Anzahl X, die zur Programmierung der in jede erste Matrix einzuschließende Anzahl Datenbits geliefert wurde, X einheitlich entsprechend jeder Dimension der ersten Matrix verteilte Positionen bestimmt werden sollen, und dass die Mittel zur Bildung der ersten Matrix so vorgesehen sind, dass Bits mit bekannten Werten an den X Positionen platziert werden, welche Bits mit bekannten Werten sich nach der systematischen Codierung an bestimmten Positionen der zweiten Binärmatrix befinden und nicht zum Kanal übertragen werden.

9. Codierer nach Anspruch 8, **dadurch gekennzeichnet, dass** die Mittel zur Programmierung (69) so vorgesehen sind, dass sie ausgehend von einer Anzahl Y, die zur Programmierung der Bitzahl der zweiten, an den Kanal übertragenen Matrix geliefert werden, Y Positionen in der zweiten Matrix ({c}) bestimmen, und dadurch, dass die Bits der zweiten Matrix, die sich an den Y Positionen befinden, nicht zum Kanal übertragen werden.

10. Codierer nach Anspruch 9, **dadurch gekennzeichnet, dass** die Mittel zur Programmierung (69) die Y Positionen im Wesentlichen einheitlich gemäß jeder Dimension der zweiten Binärmatrix ({c}) verteilen.

11. Fehler korrigierender Decodierer (17), der umfasst:

- Mittel (66) zur Bildung einer Eingangsmatrix ({R}) aus einem Signal (R(t)), das auf einem Übertragungskanal empfangen wurde, wobei sich die Eingangsmatrix aus digitalen Abtastwerten zusammensetzt, deren Vorzeichen jeweilige initiale Schätzungen von Bits einer Binärmatrix darstellen, die von einem Redundanzcodierer (12) gebildet wurde, der einen systematischen Blockcode anwendet, der dem Produkt aus systematischen Elementar-Blockcodes entspricht $(C_1, C_2)$, und deren absolute Werte jeweils Konfidenzen messen, die den initialen Schätzungen zugeordnet werden; und
- Mittel (65) zur iterativen Decodierung, die so gesteuert sind, dass sie die Eingangsmatrix gemäß aufeinander folgender Decodierzyklen einschließt, wobei jeder Decodierzyklus nacheinander Schritte (32,33) der Suche nach Codeworten für jeden Elementar-Blockcode umfasst, der bei dem erzeugten Code verwendet wird,

bei dem die Decodiermittel (65) bei jedem Schritt (32,33) der Suche nach Codeworten eine Datenmatrix ({R'}) und eine Entscheidungsmatrix ({D}) mit Binärkomponenten empfangen, die vor dem ersten Suchschritt jeweils von der Eingangsmatrix ({R}) und einer Matrix gebildet werden, deren Binärkomponenten den Vorzeichen der Abtastwerte der Eingangsmatrix ({R}) entsprechen, und für den folgenden Suchschritt eine neue Entscheidungsmatrix ({D}) erzeugen, deren Binärkomponenten neue jeweilige Schätzungen der Bits der zweiten Binärmatrix und eine neue Datenmatrix ({R'}) darstellen, deren Abtastwerte absolute Werte haben, die jeweils Konfidenzen messen, die den neuen Schätzungen zugeordnet werden, wobei decodierte Datenbits $(a_u)$ aus der beim letzten Codewortsuchschritt erzeugten Entscheidungsmatrix extrahiert werden,

und bei dem jeder Schritt (32,33) der Suche nach Codeworten eine Teilung der empfangenen Datenmatrix in Datenvektoren ([R']) umfasst, die jeweils einem Codewort des Elementarcodes entspricht, und eine entsprechende Teilung der empfangenen Entscheidungsmatrix in Entscheidungsvektoren ([D]), und Elementardecodierungen mit weichen Entscheidungen (37,42) zur Verarbeitung jeweils zumindest bestimmter Datenvektor-Datenentscheidungs-Paare,

**dadurch gekennzeichnet, dass** er ferner Mittel zur Programmierung (66) umfasst, mit denen ausgehend von einer Anzahl X, die zur Programmierung der aus der Entscheidungsmatrix zu extrahierenden Anzahl decodierter Datenbits geliefert wurde, X einheitlich entsprechend jeder Dimension einer nicht redundanten Teil-Matrix ({a}) der Binärmatrix verteilte Positionen bestimmt werden sollen, und dass die Mittel zur Bildung der Eingangsmatrix ({R}) so vorgesehen sind, dass sie digitale Abtastwerte mit bestimmten Vorzeichen, deren absolute Werte repräsentativ für eine maximale Konfidenz sind, an Positionen platzieren, die den X Positionen entsprechen.

12. Decodierer nach Anspruch 11, **dadurch gekennzeichnet, dass** die Mittel zur Programmierung (66) so vorgesehen sind, dass sie ausgehend von einer Anzahl Y, die zur Programmierung der aus dem empfangenen Signal erhaltenen Anzahl von Abtastwerten der Eingangsmatrix geliefert wurde, y Positionen in der Eingangsmatrix ({R}) bestimmt werden, und dass die Mittel zur Bildung der Eingangsmatrix so vorgesehen sind, dass sie digitale Abtastwerte, deren absolute Werte repräsentativ für eine minimale Konfidenz sind, an den Y Positionen platzieren.

13. Decodierer nach Anspruch 12, **dadurch gekennzeichnet, dass** die Mittel zur Programmierung (66) die Y Positionen im Wesentlichen einheitlich gemäß jeder Dimension der Eingangsmatrix ({R}) verteilen.

## FIG.1

```
S(t)    ┌──────────┐  X(t)  ┌──────────┐  Y(t)  ┌──────────────┐
────────│ CODEUR   │────────│ CODEUR   │────────│ MODULATEUR   │──────┐
        │ SOURCE   │        │ CANAL    │        │              │      │  E(t)
        └──────────┘        └──────────┘        └──────────────┘
            11                  12                   13
                            EMETTEUR
                        10
```

```
                                          15
        ┌─────────────────────────────────────────────────┐
        │                 RECEPTEUR                        │
        │   18           17              16                │
Ŝ(t)  ┌────────────┐ Z(t) ┌──────────┐ R(t) ┌──────────────┐  αE(t)
──────│ DECODEUR   │──────│ DECODEUR │──────│ DEMODULATEUR │────
        │ SOURCE     │      │ CANAL    │      │              │
        └────────────┘      └──────────┘      └──────────────┘
```

## FIG.2

```
┌──────────────────────────┐
│ Ranger $k_1$ x $k_2$ bits $a_j$│
│ successifs en une matrice│ - - - →   $\{a\} = \left( \quad \right) \bigg\downarrow k_1$
│ $\{a\}$ à $k_1$ lignes et│                         $\overbrace{\qquad}^{k_2}$
│ $k_2$ colonnes           │
└──────────────────────────┘ 21
            │
            ▼
┌──────────────────────────┐
│ Appliquer le code $C_2$ aux│
│ $k_1$ lignes de $\{a\}$ pour│ - - - →  $\{b\} = \left( \{a\} \;\vdots\; \quad \right) \bigg\downarrow k_1$
│ obtenir une matrice $\{b\}$│
│ à $k_1$ lignes et $n_2$ colonnes│
└──────────────────────────┘ 22
            │
            ▼
┌──────────────────────────┐ 23
│ Appliquer le code $C_1$ aux│
│ $n_2$ colonnes de $\{b\}$ pour│
│ obtenir une matrice $\{c\}$│   $\{c\} = \left( \begin{array}{c:c} \{a\} & \\ \hdashline & \end{array} \right) \begin{array}{l} k_1 \\ n_1 \end{array}$
│ à $n_1$ lignes et $n_2$ colonnes│
└──────────────────────────┘
            │
            ▼
┌──────────────────────────┐
│ Adresser successivement  │
│ les $c_j$ au modulateur  │ 24
└──────────────────────────┘
```

*FIG.3*

Réception de $n_1$ x $n_2$
échantillons $R_{j1,j2}$
___
Formation de la
matrice d'entrée {R} ———30

$i = 0$
{R'} = {R}
{D} = sgn{R} ———31

j2 = j2 +1 | i = i + 1
j2 = 1 | i = i + 1
j1 = 1 | j1 = j1 + 1

39 | 36 | 41 | 44

Décodage $C_1$, colonne j2
Calcul des $D_{j, j2}$ et $R'_{j, j2}$
$1 < j < n_1$

37

Décodage $C_2$, ligne j1
Calcul des $D_{j1, j}$ et $R'_{j1, j}$
$1 < j < n_2$

42

non — j2 = $n_2$ ? — oui
38

non — j1 = $n_1$ ? — non
43 — oui

32

33

non — i = 2m ? 
45 — oui

$\hat{a}_{j1,j2} = D_{j1,j2}$
46— $1 \leqslant j1 \leqslant k_1$
$1 \leqslant j2 \leqslant k_2$

*FIG.4*

vecteur de données $\begin{bmatrix} R' \end{bmatrix}\Big\}$
vecteur de décision $\begin{bmatrix} D \end{bmatrix}\Big\}$

Repérer les p composantes
les moins fiables de $[R']$ —51

Construire q séquences
de test $[T^1],\ldots\ldots,[T^q]$
et q mots à décoder
$[U^s] = [T^s] \oplus [D]$ —52

Décodage algébrique de $[D]$
et des q mots $[U^1],\ldots\ldots,[U^q]$
obtention de q' mots de code
$[C^1],\ldots\ldots,[C^{q'}]$ —53

Sélection de mots de code
$[C^d]$ et $[C^c]$ qui minimisent
$M^s = \|[C^s] - [R']\|^2$ —54
avec $M^d < M^c$

$j = 1$ —55

56

non — $C_j^c \neq C_j^d$ ? — oui

$W_j = (\beta_i - C_j^d.R_j')C_j^d$

59

58— $W_j = \left(\dfrac{(M^c - M^d)}{4} - C_j^d.R_j'\right)C_j^d$

$j = j + 1$ —61

non — $j = n_l$ ? — oui

60

$[R'] = [R] + \alpha_i[W]$ —62
$[D] = [C^d]$

fin

*FIG.5*

*FIG.13*

*FIG.14*

## FIG.6

## FIG.7

## FIG.8

```
{h}={0}, i=j=nx=0 ─── 80
```

$$nx < X \ ?$$  — 81

oui → 82: $i = 1+(i \bmod k_1)$, $j = 1+(j \bmod k_2)$

non → CALCUL $x(u)$, $y(u)$, $1 \leqslant u \leqslant k-X$  — 86

$$h_{i,j} = 0 \ ?$$  — 83

oui → 85: $h_{i,j} = 1$, $nx = nx + 1$

non → 84: $j = 1+(j \bmod k_2)$

## FIG.9

## FIG.10

i = j = ny = 0 —100

ny < Y ? —101

oui

i = 1+(i mod n₁)
j = 1+(j mod n₂) —102

non

CALCUL
x'(v), y'(v)
1 ≤ v ≤ n−X−Y —106

h_{i,j} = 0 ? —103

oui

h_{i,j} = 2
ny = ny + 1 —105

non

i = 1+(i mod n₁) —104

## FIG.11

# FIG.12